# EUROPEAN PATENT APPLICATION

(11) **EP 4 757 552 A1**
(43) Date of publication of application: **10.06.2026**
(21) Application number: 25221223.8
(22) Date of filing: 05.12.2025
(51) Int. Cl.: H10K 50/15, H10K 50/18, H10K 59/80

(54) **LIGHT EMITTING DEVICE AND LIGHT EMITTING DISPLAY DEVICE INCLUDING THE SAME**

(30) Priority: 05.12.2024 KR 20240179539
(71) Applicant: LG Display Co., Ltd., Seoul 150-721 (KR)
(72) Inventor: KIM, Mi Na, Paju-si (KR); KIL, Moon Sung, Paju-si (KR); LEE, Eun Hyung, Paju-si (KR); KIM, Yong Cheol, Paju-si (KR)
(74) Representative: Morrall, Jonathan Ian McLachlan

(57) **Abstract**

Disclosed are a light emitting device and a light emitting display device including the light emitting device. The light emitting device includes a first electrode and a second electrode facing each other, a light emitting layer between the first electrode and the second electrode, a hole transport common layer between the first electrode and the light emitting layer, and an electron transport common layer between the light emitting layer and the second electrode, a first hole transport auxiliary layer and a second hole transport auxiliary layer provided sequentially between the hole transport common layer and the light emitting layer, and an electron blocking layer between the second hole transport auxiliary layer and the light emitting layer. A highest occupied molecular orbital (HOMO) energy level of the second hole transport auxiliary layer can be higher than a HOMO energy level of the first hole transport auxiliary layer and a HOMO energy level of the electron blocking layer respectively located on opposite sides of the second hole transport auxiliary layer.

## Description

### CROSS-REFERENCE TO RELATED APPLICATIONS

This application claims priority to Korean Patent Application No. 10-2024-0179539, filed in the Republic of Korea on December 5, 2024, which is hereby incorporated by reference as if fully set forth herein.

### Field of the Invention

The present disclosure relates to a light emitting device, and more specifically, to a light emitting device that has improved discharge characteristics and improved electroluminescent characteristics by changing the configuration adjacent to a light emitting layer in the light emitting device, and a light emitting display device including the same.

### Discussion of the Related Art

There is increasing demand for various forms of display devices for displaying information via images in a current era.

A light emitting display device in current development includes light emitting devices to constitute pixels that do not require a separate light source unit and such light emitting devices are advantageous for slimness or flexibility and for having excellent color purity.

For example, such a light emitting device includes two different electrodes and a light emitting layer between the electrodes to emit light of different colors to provide an image to convey information.

### SUMMARY OF THE DISCLOSURE

Accordingly, the present disclosure is directed to a light emitting device and a light emitting display device including the same that substantially obviate one or more problems due to limitations and disadvantages of the related art.

The light emitting display device displays an image as each of subpixels is repeatedly turned on and off.

The light emitting display device has light emitting devices in the respective subpixels, and light emitting layers that emits different colors are used for the light emitting devices to display different colors. In addition, the light emitting device further has a separate functional layer along with the light emitting layer to provide an optical effect.

The light emitting layer of the light emitting device receives holes and electrons, and the holes and electrons recombine in the light emitting layer to generate excitons which are used for light emission.

However, in a structure provided with multiple functional layers to trap holes and electrons in the light emitting layer of the light emitting device, a phenomenon occurs in which the holes and electrons transferred to the light emitting layer are not discharged to both the electrodes in the off state and remain, resulting in leakage light.

An object of the present disclosure is to provide a light emitting device that prevents the phenomenon of trailing shadow in which brightness before an off state is delayed due to discharge delay when switched to the off state and improves the electroluminescent characteristics and a light emitting display device including the same.

Additional advantages, objects, and features of the invention will be set forth in part in the description which follows and in part will become apparent to those having ordinary skill in the art upon examination of the following or can be learned from practice of the invention. The objectives and other advantages of the invention can be realized and attained by the structure particularly pointed out in the written description and claims hereof as well as the appended drawings.

In one embodiment of the present disclosure, a light emitting device is capable of maintaining a micro-cavity effect within a subpixel while solving low-grayscale defects by changing the configuration of an optical compensation layer among the components of the light emitting device provided in the subpixel.

To achieve these objects and other advantages and in accordance with the purpose of the invention, as embodied and broadly described herein, a light emitting device includes a first electrode and a second electrode facing each other, a light emitting layer between the first electrode and the second electrode, a hole transport common layer between the first electrode and the light emitting layer, and an electron transport common layer between the light emitting layer and the second electrode, a first hole transport auxiliary layer and a second hole transport auxiliary layer provided sequentially between the hole transport common layer and the light emitting layer, and an electron blocking layer between the second hole transport auxiliary layer and the light emitting layer. A highest occupied molecular orbital (HOMO) energy level of the second hole transport auxiliary layer can be higher than a HOMO energy level of each of the first hole transport auxiliary layer and the electron blocking layer located on both sides of the second hole transport auxiliary layer.

In another aspect of the present disclosure, a light emitting display device includes a substrate including a green subpixel, a red subpixel, and a blue subpixel, a first electrode provided in each of the green subpixel, the red subpixel, and the blue subpixel, a hole transport common layer on the first electrode over the green subpixel, the red subpixel, and the blue subpixel, a green light emitting layer, a red light emitting layer, and a blue light emitting layer provided on the hole transport common layer at each of the green subpixel, the red subpixel, and the blue subpixel, a first hole transport auxiliary layer, a second hole transport auxiliary layer, and an electron blocking layer provided sequentially between the hole transport common layer and the green light emitting layer at the green subpixel, an electron transport common layer on the green light emitting layer, the red light emitting layer, and the blue light emitting layer over the green subpixel, the red subpixel, and the blue subpixel, and a second electrode on the electron transport common layer. A highest occupied molecular orbital (HOMO) energy level of the second hole transport auxiliary layer can be higher than a HOMO energy level of each of the first hole transport auxiliary layer and the electron blocking layer located on both sides of the second hole transport auxiliary layer.

It is to be understood that both the foregoing general description and the following detailed description of the present disclosure are exemplary and explanatory and are intended to provide further explanation of the invention as claimed.

### BRIEF DESCRIPTION OF THE DRAWINGS

The accompanying drawings, which are included to provide a further understanding of the invention and are incorporated in and constitute a part of this application, illustrate embodiment(s) of the invention and together with the description serve to explain the principle of the invention. In the drawings:
FIG. 1 is a schematic diagram illustrating a light emitting display device according to one embodiment of the present disclosure;
FIG. 2 is a cross-sectional view illustrating a light emitting device provided in one subpixel of FIG. 1 according to one embodiment of the present disclosure;
FIG. 3 is an energy band diagram of the light emitting device of FIG. 2;
FIG. 4 is a cross-sectional view illustrating light emitting devices of subpixels of a light emitting display device according to one embodiment of the present disclosure;
FIG. 5 is a graph showing JV characteristics of a green light emitting device of FIG. 4;
FIG. 6 is a graph showing CV characteristics of the green light emitting device of FIG. 4;
FIG. 7 is a graph showing the luminance characteristics as a function of current density of the green light emitting device of FIG. 4;
FIG. 8 is a graph showing the JV characteristics of the light emitting device of the red subpixel of FIG. 4;
FIG. 9 is a graph showing the CV characteristics of the light emitting device of the red subpixel of FIG. 4;
FIG. 10 is a graph showing the luminance characteristics as a function of current density of the light emitting device of the red subpixel of FIG. 4; and
FIG. 11 is a cross-sectional view illustrating a light emitting display device according to one embodiment of the present disclosure.

### DETAILED DESCRIPTION OF THE EMBODIMENTS

Advantages and features of the present disclosure, and a method of achieving the advantages and features will become apparent with reference to the example embodiments described herein in detail together with the accompanying drawings. The present disclosure should not be construed as limited to the example embodiments as disclosed below, and can be embodied in various different forms. Thus, these example embodiments are set forth only to make the present disclosure sufficiently complete, and to assist those skilled in the art to fully understand the scope of the present disclosure. The protected scope of the present disclosure is defined by the claims and their equivalents.

In the following description of the present disclosure, where the detailed description of the relevant known steps, elements, functions, technologies, and configurations can unnecessarily obscure an important point of the present disclosure, a detailed description of such steps, elements, functions, technologies, and configurations can be omitted. In addition, the names of elements used in the following description are selected in consideration of clarity of description of the specification, and can differ from the names of elements of actual products. Furthermore, in the following detailed description of the present disclosure, numerous specific details are set forth in order to provide a sufficiently thorough understanding of the present disclosure. However, it will be understood that the present disclosure can be practiced without these specific details. In other instances, known methods, procedures, components, and circuits have not been described in detail so as not to unnecessarily obscure aspects of the present disclosure.

The shapes, sizes, ratios, angles, numbers, and the like, which are illustrated in the drawings to describe various example embodiments of the present disclosure are merely given by way of example. The disclosure is not limited to the illustrations in the drawings.

In the present specification, where terms such as "including," "having," "comprising," and the like are used, one or more components can be added, unless the term, such as "only," is used. As used herein, the term "and/or" includes a single associated listed item and any and all of the combinations of two or more of the associated listed items.

An expression such as "at least one of" when preceding a list of elements can modify the entire list of elements and need not modify the individual elements of the list. The term "at least one" should be understood as including any and all combinations of one or more of the associated listed items. For example, the meaning of "at least one of a first element, a second element, and a third element" encompasses the combination of all three listed elements, combinations of any two of the three elements, as well as each individual element, the first element, the second element, and the third element.

The terminology used herein is to describe particular aspects and is not intended to limit the present disclosure. As used herein, the terms "a" and "an" used to describe an element in the singular form is intended to include a plurality of elements. An element described in the singular form is intended to include a plurality of elements, and vice versa, unless the context clearly indicates otherwise.

In construing a component or numerical value, the component or the numerical value is to be construed as including an error or tolerance range even where no explicit description of such an error or tolerance range is provided.

In describing the various example embodiments of the present disclosure, where the positional relationship between two elements is described using terms, such as "on", "above", "under" and "next to", at least one intervening element can be present between the two elements, unless "immediate(ly)" or "direct(ly)" or "close(ly) is used. It will be understood that when an element or layer is referred to as being "connected to", or "coupled to" another element or layer, it can be directly connected to or coupled to the other element or layer, or one or more intervening elements or layers can be present.

In describing the various example embodiments of the present disclosure, when terms such as "after," "subsequently," "next," and "before," are used to describe the temporal relationship between two events, another event can occur therebetween, unless a more limiting term, such as "just," "immediate(ly)," or "directly" is used.

In describing the various example embodiments of the present disclosure, terms such as "first" and "second" can be used to describe a variety of components. These terms aim to distinguish the same or similar components from one another and do not limit the components. Accordingly, throughout the specification, a "first" component can be the same as a "second" component within the technical concept of the present disclosure, unless specifically mentioned otherwise.

Features of various embodiments of the present disclosure can be partially or overall coupled to or combined with each other, and can be variously inter-operated with each other and driven technically as those skilled in the art can sufficiently understand. The embodiments of the present disclosure can be carried out independently from each other, or can be carried out together in a co-dependent relationship.

As used herein, the term "doped" layer refers to a layer including a first material and a second material (for example, n-type and p-type materials, or organic and inorganic substances) having physical properties different from the first material. Apart from the differences in properties, the first and second materials can also differ in terms of their amounts in the doped layer. For example, the host material can be a major component while the dopant material can be a minor component. The first material accounts for most of the weight of the doped layer. The second material can be added in an amount less than 30% by weight, based on a total weight of the first material in the doped layer. A "doped" layer can be a layer that is used to distinguish a host material from a dopant material of a certain layer, in consideration of the weight ratio. For example, if all of the materials constituting a certain layer are organic materials, at least one of the materials constituting the layer is n-type and the other is p-type, when the n-type material is present in an amount of less than 30 wt%, or when the p-type material is present in an amount of less than 30 wt%, the layer is considered to be a "doped" layer.

Further, the term "undoped" refers to layers that are not "doped". For example, a layer can be an "undoped" layer when the layer contains a single material or a mixture including materials having the same properties as each other. For example, if at least one of the materials constituting a certain layer is p-type and none of the materials constituting the layer are n-type, the layer is considered to be an "undoped" layer. For example, if at least one of the materials constituting a layer is an organic material and none of the materials constituting the layer are inorganic materials, the layer is considered to be an "undoped" layer.

In this present disclosure, an electroluminescence (EL) spectrum can be calculated by multiplying (a) a photoluminescence (PL) spectrum, which applies the inherent characteristics of an emissive material such as a dopant material or a host material included in an organic emission layer, by (b) an out-coupling or emittance spectrum curve, which is determined by the structure and optical characteristics of an organic light-emitting element including the thicknesses of organic layers such as, for example, an electron transport layer.

The term "can" fully encompasses all the meanings and coverages of the term "may."

Hereinafter, example embodiments of the present disclosure will be described in detail with reference to the accompanying drawings. In adding reference numerals to elements of each of the drawings, although the same elements are illustrated in other drawings, like reference numerals can refer to like elements.

Hereinafter, example embodiments according to the present disclosure will be described in detail with reference to the attached drawings.

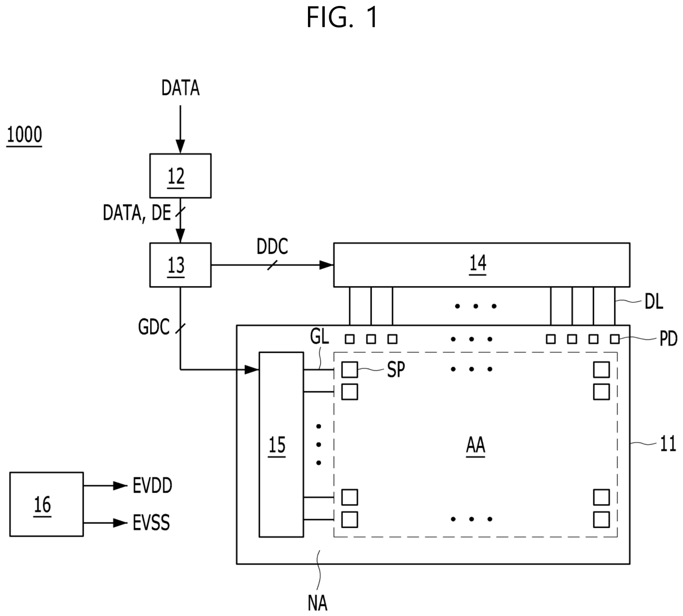

FIG. 1 is a schematic diagram illustrating a light emitting display device according to one embodiment of the present disclosure. All components of each light emitting display device according to all embodiments of the present disclosure are operatively coupled and configured.

As shown in FIG. 1, a light emitting display device 1000 according to an embodiment of the present disclosure includes a display panel 11, an image processor 12, a timing controller 13, a data driver 14, a scan driver 15, and a power supply 16.

The display panel 11 displays an image in response to a data signal DATA supplied from the data driver 14, a scan signal supplied from the scan driver 15, and power supplied from the power supply 16.

The display panel 11 can include subpixels SP disposed at each intersection of a plurality of gate lines GL and a plurality of data lines DL. The structure of the subpixel SP can vary depending on the type of the light emitting display device 1000.

For example, the subpixels SP can be formed in a top emission method, a bottom emission method, or a dual emission method depending on the structure. The subpixels SP are units that can emit light of their own color with or without a specific type of color filter. For example, the subpixels SP can include a red subpixel, a green subpixel, and a blue subpixel. Alternatively, the subpixel SP can include, for example, a red subpixel, a blue subpixel, a white subpixel, and a green subpixel, but other color subpixels are also possible. The subpixels SP can have one or more different light emitting portions depending on the light emitting characteristics. For example, the blue subpixel and the subpixels emitting light with different color can have different light emitting portions.

One or more subpixels SP can constitute one unit pixel. For example, one unit pixel can include red, green, and blue subpixels, and the red, green, and blue subpixels can be repeatedly disposed. Alternatively, one unit pixel can include red, green, blue, and white subpixels, and the red, green, blue, and white subpixels can be disposed repeatedly, or the red, green, blue, and white subpixels can be disposed in quads. In an embodiment according to the present disclosure, the color type, arrangement type, arrangement order, or the like of the subpixels can be determined depending on the light emission characteristics, lifespan of the device, device specifications, etc., and are not limited thereto.

The display panel 11 can be divided into a display area (AA: inside a dotted area) where subpixels SP are disposed to display an image, and a non-display area NA around the display area AA. The scan driver 15 can be mounted in the non-display area NA of the display panel 11. In addition, the non-display area NA can include a pad portion PAD including a pad electrode PD.

Here, the display area AA is also called an "active area" and the non-display area NA is also called a "non-active area".

The image processor 12 can output a data enable signal DE in addition to a data signal DATA supplied from the outside. The image processor 12 can output one or more of a vertical synchronization signal, a horizontal synchronization signal, and a clock signal in addition to the data enable signal DE, but these signals are omitted for convenience of description.

The timing controller 13 can receive a data signal DATA in addition to a driving signal from the image processor 12. The driving signal can include a data enable signal DE. In addition, the driving signal can include a vertical synchronization signal, a horizontal synchronization signal, and a clock signal. The timing controller 13 outputs a data timing control signal DDC for controlling the operation timing of the data driver 14 and a gate timing control signal GDC for controlling the operation timing of the scan driver 15 based on the driving signal.

The data driver 14 samples and latches the data signal DATA supplied from the timing controller 13 in response to the data timing control signal DDC supplied from the timing controller 13, converts the resulting the data signal DATA into a gamma reference voltage, and outputs the gamma reference voltage.

The data driver 14 can output the data signal DATA through the data lines DL. The data driver 14 can be provided as an integrated circuit IC. For example, the data driver 14 can be electrically connected to the pad electrode PD disposed in the non-display area NA of the display panel 11 through a flexible circuit film.

The scan driver 15 can output a scan signal in response to the gate timing control signal GDC supplied from the timing controller 13. The scan driver 15 can output a scan signal through the gate lines GL. The scan driver 15 can be implemented in the form of an integrated circuit IC or can be implemented in the display panel 11 in the form of a gate in panel GIP.

The power supply 16 can output a high potential voltage and a low potential voltage for driving the display panel 11. The power supply 16 can supply a high potential voltage to the display panel 11 through a first power line EVDD (driving power line or pixel power line) and supply a low potential voltage to the display panel 11 through a second power line EVSS (auxiliary power line or a common power line).

The display panel 11 is divided into a display area AA and a non-display area NA, and include a plurality of subpixels SP defined by gate lines GL and data lines DL which cross each other in the display area AA to form a matrix.

The subpixels SP can include emitting subpixels that emit at least two among red light, green light, blue light, yellow light, magenta light, and cyan light. In addition, the subpixels SP can emit their own color with or without a specific type of color filter, but the present disclosure is not necessarily limited thereto. The color type, arrangement type, and arrangement order of the subpixels SP can be determined depending on light emission characteristics, lifespan of the device, and device specifications.

Each of the subpixels SP can include a light emitting portion that emits light and a non-light emitting portion around the light emitting portion.

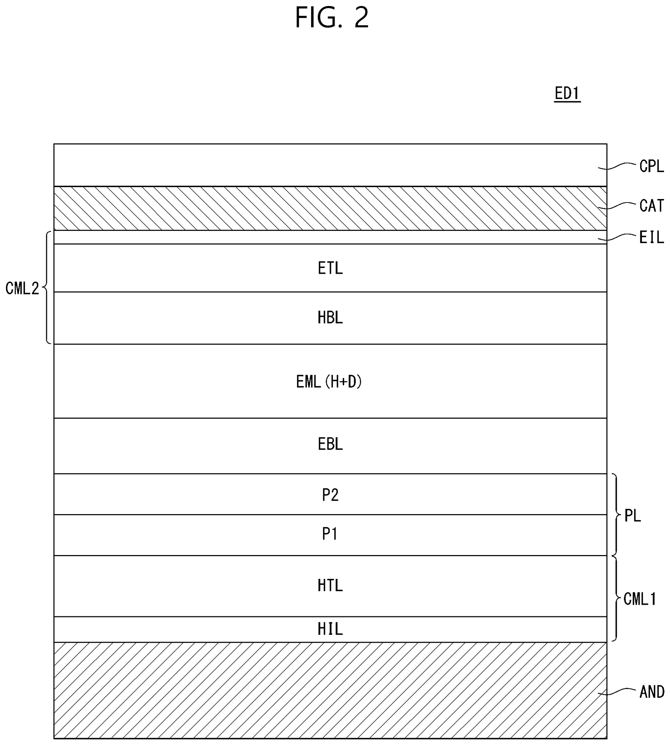

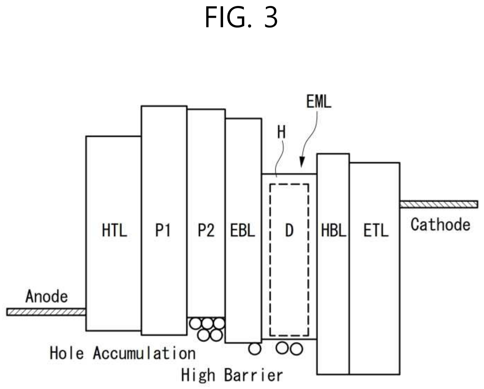

FIG. 2 is a cross-sectional view illustrating a light emitting device provided in one subpixel of FIG. 1 according to one embodiment of the present disclosure. FIG. 3 is an energy band diagram of the light emitting device of FIG. 2.

As shown in FIGS. 2 and 3, the light emitting device according to one embodiment of the present disclosure includes a first electrode AND and a second electrode CAT which face each other, a light emitting layer EML provided between the first electrode AND and the second electrode CAT, a hole transport common layer CML1 provided between the first electrode AND and the light emitting layer EML, an electron transport common layer CML2 provided between the light emitting layer EML and the second electrode CAT, and a first hole transport auxiliary layer P1, a second hole transport auxiliary layer P2, and an electron blocking layer EBL which are sequentially provided between the hole transport common layer CML1 and the light emitting layer EML.

The first electrode AND can be an anode and the second electrode CAT can be a cathode.

The first electrode AND can include, for example, a metal material having high reflectivity or a transparent electrode. For example, the first electrode AND can be formed as a single layer structure of a transparent conductive film such as ITO (indium tin oxide), IZO (indium zinc oxide), TO (tin oxide), or ITZO (indium tin zinc oxide), as a multilayer structure such as a stacked structure of aluminum (Al) and titanium (Ti) (Ti/Al/Ti), a stacked structure of aluminum (Al) and ITO (ITO/Al/ITO), an APC (Ag/Pd/Cu) alloy, a stacked structure of an APC alloy and ITO (ITO/APC/ITO), a stacked structure of silver (Ag) and molybdenum/titanium alloy (Ag/MoTi), or as a single layer structure containing one material selected from silver (Ag), aluminum (Al), molybdenum (Mo), gold (Au), magnesium (Mg), calcium (Ca), and barium (Ba), or an alloy of two or more thereof, but embodiments of the present disclosure are not limited thereto, and other materials can also be used. When the first electrode AND is formed of a single layer of a transparent conductive film, light from the light emitting device ED can be emitted through the first electrode AND. When the first electrode AND includes a reflective electrode, light can be emitted through the second electrode CAT facing the first electrode AND.

In a top-emitting type light emitting display device, the second electrode CAT can include a transparent electrode or a thin reflective-transparent electrode that can transmit light so that light can be transmitted through the second electrode CAT. The transparent electrode can be, for example, ITO or IZO, and the reflective-transparent electrode can be formed of, for example, one selected from silver (Ag), aluminum (Al), molybdenum (Mo), gold (Au), magnesium (Mg), ytterbium (Yb), and strontium (Sr), or an alloy material of two or more thereof, but embodiments of the present disclosure are not limited thereto, and other materials can also be used.

Alternatively, in a bottom-emitting light emitting display device, the second electrode CAT can include a reflective electrode. For example, the reflective electrode can include one selected from silver (Ag), aluminum (Al), molybdenum (Mo), gold (Au), magnesium (Mg), calcium (Ca), and barium (Ba), or an alloy of two or more thereof, but is not limited to these examples. The second electrode CAT can be a light-transmitting electrode. The second electrode CAT can include a transparent metal material (TCO, transparent conductive material) such as ITO (indium tin oxide), IZO (indium zinc oxide) that can transmit light, or a semi-transparent metal material such as magnesium (Mg), silver (Ag), or an alloy of magnesium (Mg) and silver (Ag), but embodiments of the present disclosure are not limited thereto, and other materials can also be used. When the second electrode CAT includes a semi-transparent metal material, the light emission efficiency can be increased by the microcavity effect. When the second electrode CAT includes a semi-transparent metal material, the thickness thereof is thin enough to allow light to pass therethrough.

The hole transport common layer CML1 is a layer that injects holes from the first electrode AND and transfers the holes to the light emitting layer EML, and can include multiple configurations. The hole transport common layer CML1 can include, for example, a hole injection layer HIL and a hole transport layer HTL, but embodiments of the present disclosure are not limited thereto, and other layer can also be included.

The hole injection layer HIL directly contacts the first electrode AND, which is a metal of a reflective electrode or a transparent electrode component, and has the function to lower the energy barrier at the interface with the first electrode AND. The hole injection layer HIL can include an inorganic material of metal fluoride to lower the energy barrier at the interface with the first electrode AND. Alternatively, the hole injection layer HIL can include a p-type dopant in the hole transport organic material.

The hole transport layer HTL can include a hole transport material. For example, the hole transport material can include at least one of NPD (N,N-dinaphthyl-N,N'-diphenylbenzidine), TPD (N,N'-bis-(3-methylphenyl)-N,N'-bis-(phenyl)-benzidine), spiro-TAD (2,2',7,7'-Tetrakis(N,N-diphenylamino)-9,9-spirobifluorene) or MTDATA (4,4',4"-Tris(N-3-methylphenyl-N-phenyl-amino)-triphenylamine), but is not limited thereto.

The electron blocking layer EBL functions to prevent electrons from passing from the light emitting layer EML. For this function, the electron blocking layer EBL includes a material having a lowest unoccupied molecular orbital (LUMO) energy level higher than that of the light emitting layer. In addition, the electron blocking layer EBL prevents delays of hole transport between the hole transport layer HTL and the light emitting layer EML and includes a material having a large energy band gap among the hole transport materials.

The light emitting layer EML includes a host H and a dopant D. Depending on the color of light emitted from the light emitting layer EML, the host H and the dopant D can have different components.

When the light emitting layer EML includes a dopant D having an emission peak at a wavelength of 430 nm to 495 nm, the light emitting layer EML can emit blue light. The dopant D of the blue light emitting layer can include a boron-based fluorescent dopant to improve efficiency and provide a predetermined lifespan.

When the light emitting layer EML includes a dopant D having an emission peak at a wavelength of 500 nm to 595 nm, the light emitting layer EML can emit green light. The dopant D of the green light emitting layer can include an iridium-based phosphorescent dopant to provide a predetermined luminance.

When the light emitting layer EML includes a dopant D having an emission peak at a wavelength of 600 nm to 650 nm, the light emitting layer EML can emit red light. The dopant D of the red light emitting layer can include an iridium-based phosphorescent dopant to provide a predetermined luminance. The dopant D of the red light emitting layer can adjust the emission wavelength to a long wavelength by changing the substituent.

The dopant D has a different material depending on the emission wavelength and therefore, the host material has an energy band gap and triplet energy level to optimize the excitation of the dopant D.

The electron transport common layer CML2 can include a hole blocking layer HBL, an electron transport layer ETL, and an electron injection layer EIL.

The hole blocking layer HBL is located on the opposite side of the electron blocking layer EBL with the light emitting layer EML disposed therebetween and functions to restrict holes so that they do not escape from the light emitting layer EML and contribute to excitation.

The electron injection layer EIL functions to reduce the energy barrier when electrons are injected from the second electrode CAT into the organic material. The electron injection layer EIL is formed with a relatively small thickness compared to the electron transport layer ETL and can include a metal such as an alkali metal, an alkaline earth metal or a transition metal, and a halogen material.

The electron transport layer ETL functions to transfer electrons injected from the second electrode CAT into the electron injection layer EIL to the light emitting layer EML. The electron transport layer ETL can include at least one selected from the group consisting of, for example, Alq3 (tris(8-hydroxyquinolino aluminum), PBD, TAZ, spiro-PBD, BAlq, Liq(lithium quinolate), BMB-3T, PF-6P, TPBI, COT, and SAlq, but the present disclosure is not limited thereto.

A light emitting device according to one embodiment of the present disclosure is characterized in that the hole transport auxiliary layer PL includes first and second hole transport auxiliary layers P1 and P2 formed of different materials. In the embodiment of the present disclosure, the hole transport auxiliary layer PL can include three or more layer that have at least one common material, but embodiments of the present disclosure are not limited thereto.

As shown in FIG. 3, the second hole transport auxiliary layer P2 contacts the first hole transport auxiliary layer P1 on one side thereof and contacts the electron blocking layer EBL on the other side thereof.

The highest occupied molecular orbital (HOMO) energy level of the second hole transport auxiliary layer P2 is higher than that of each of the first hole transport auxiliary layer P1 and the electron blocking layer EBL located on both or opposite sides of the second hole transport auxiliary layer P2.

The second hole transport auxiliary layer P2 has a higher HOMO energy level than the adjacent layers when holes flow from the light emitting layer EML to the first electrode AND in the off state and discharge occurs, and thus can be temporarily and quickly accumulate holes, thus preventing the phenomenon in which holes do not remain at the interface between the light emitting layer EML and the electron blocking layer EBL in the off state, and thus the charge remaining at the interface between the light emitting layer EML and the electron blocking layer EBL flow back to the light emitting layer, causing low-grayscale leakage light even at a low voltage.

In addition, the HOMO energy level of the second hole transport auxiliary layer P2 is higher than the HOMO energy level of the light emitting layer. This aims at allowing holes to smoothly move to the higher HOMO energy level side in the off state.

The HOMO energy level of the second hole transport auxiliary layer P2 can have a difference of 0.25 eV or more from the HOMO energy level of the electron blocking layer EBL in contact with the second hole transport auxiliary layer P2. The second hole transport auxiliary layer P2 can have a HOMO energy level that is greatly different from that of the electron blocking layer EBL and can also rapidly move holes from the electron blocking layer EBL through a giant surface potential GSP with the electron blocking layer EBL.

When the light emitting device of the subpixel is switched from the on state to the off state, the holes remaining in the light emitting layer escape to the first electrode AND and the electrons escape to the second electrode CAT, resulting in discharge. However, when holes and electrons released from the light emitting layer EML do not pass to the adjacent layer but accumulate at the interface on both sides of the light emitting layer, the discharge is delayed. In particular, holes or electrons remaining at the interface adjacent to the light emitting layer EML can be observed as weak leakage light. The light emitting device according to the embodiment of the present disclosure has a configuration in which a second hole transport auxiliary layer P2 having a higher HOMO energy level than the adjacent layers is disposed on one side of the electron blocking layer EBL so as to rapidly transfer holes from the electron blocking layer EBL adjacent to the light emitting layer EML in the off state, so that the holes remaining in the light emitting layer EML during the discharge smoothly pass over the electron blocking layer and accumulate in the second hole transport auxiliary layer P2. As such, the light emitting device according to the embodiment of the present disclosure can increase the threshold voltage Vth of the electrostatic capacity of the light emitting device by provision of a second hole transport layer P2 having a HOMO energy level that is relatively higher than that of the electron blocking layer EBL, thus preventing low-grayscale leakage.

The second hole transport auxiliary layer P2 temporarily accumulates holes between the first hole transport auxiliary layer P1 and the electron blocking layer EBL, and functions as a well layer. For this purpose, the second hole transport auxiliary layer P2 can have an energy band gap smaller than the energy band gap of each of the first hole transport auxiliary layer P1 and the electron blocking layer EBL. During the discharge process, the holes accumulated in the second hole transport auxiliary layer P2 escape toward the first electrode AND over time. Although the second hole transport auxiliary layer P2 temporarily accumulates holes, it is separated from the light emitting layer EML via the electron blocking layer EBL disposed therebetween, and has a large HOMO energy level difference from the electron blocking layer EBL, thus acting as a large energy barrier to prevent the holes remaining in the first hole transport auxiliary layer P1 in the off state from passing to the electron blocking layer EBL.

By adjusting the thickness of the hole transport auxiliary layer PL including the first and second hole transport auxiliary layers P1 and P2 in the light emitting device, the position of the light emitting layer EML between the first and second electrodes AND and CAT can be controlled. The total thickness of the hole transport auxiliary layer PL having the optimal microcavity effect depending on color of emitted light can be different.

The thickness of the first hole transport auxiliary layer P1 in the hole transport auxiliary layer PL can be proportional to the wavelength of each color of emitted light.

For example, when the light emitting device ED1 has a light emitting layer EML that emits green light, the first hole transport auxiliary layer P1 can have a thickness proportional to any one wavelength in the range of 500 nm to 595 nm, but embodiments of the present disclosure are not limited thereto, and other wavelengths can also be used.

The first hole transport auxiliary layer P1 occupies a major thickness in the entire thickness of the hole transport auxiliary layer PL and is responsible for the main optical function of the hole transport auxiliary layer PL. By adjusting the thickness of the first hole transport auxiliary layer P1, the vertical position of the light emitting layer EML within the light emitting device ED1 is adjusted and the micro-cavity characteristics are thus controlled. The first hole transport auxiliary layer P1 has a refractive index of 2.0 or more, thus improving the micro-cavity characteristics and the luminance viewing angle characteristics.

The first hole transport auxiliary layer P1 has higher hole mobility than the second hole transport auxiliary layer P2. The first hole transport auxiliary layer P1 has a high hole mobility and thus smoothly transfer holes to the hole transport layer HTL and the light emitting layer EML when the light emitting device is turned on, thereby lowering the driving voltage.

The first hole transport auxiliary layer P1 can have a HOMO energy level lower than the second hole transport auxiliary layer P2 and the hole transport layer HTL on both adjacent sides. Relatively, a HOMO energy level difference between the first hole transport auxiliary layer P1 and the second hole transport auxiliary layer P2 can be smaller than a HOMO energy level difference between the first hole transport auxiliary layer P1 and the hole transport layer HTL. The HOMO energy level difference between the first hole transport auxiliary layer P1 and the hole transport layer HTL can be smaller than about 0.15 eV. In some cases, the HOMO energy level of the first hole transport auxiliary layer P1 can be almost the same as the HOMO level of the hole transport layer HTL.

The second hole transport auxiliary layer P2 has a HOMO energy level higher than that of each of the hole transport layer HTL, the first hole transport auxiliary layer P1, and the electron blocking layer EBL related to hole transport or hole transfer, and generates a giant surface potential at the interface with the electron blocking layer EBL and has a function of reducing the capacitance of the light emitting device.

The second hole transport auxiliary layer P2 has a HOMO energy level higher than the electron blocking layer EBL and the first hole transport auxiliary layer P1 on both sides thereof, and accumulates holes and can rapidly discharge holes between the light emitting layer EML and the electron blocking layer EBL. In addition, the second hole transport auxiliary layer P2 increases the threshold voltage of the electrostatic capacitance of the light emitting device and reduces the low-grayscale efficiency. Therefore, the second hole transport auxiliary layer P2 can prevent low-grayscale leakage of the light emitting device.

The second hole transport auxiliary layer P2 can have a lower refractive index than the first hole transport auxiliary layer P1. For example, the refractive index of the second hole transport auxiliary layer P2 can be 2.0 or less.

The second hole transport auxiliary layer P2 has a thickness corresponding to about 1/30 to 1/3 of the total thickness of the hole transport auxiliary layer PL, which is thinner than the first hole transport auxiliary layer P1. The second hole transport auxiliary layer P2 has a thickness of about 30Å to 70Å and accumulates holes during discharge in the off-state, but does not cause hole transport delay when the light emitting device is turned on upon application of a voltage of a predetermined level or higher.

When three or more hole transport auxiliary layers are provided between the hole transport layer and the electron blocking layer, one hole transport auxiliary layer having the highest HOMO energy level among the three or more hole transport auxiliary layers can be immediately adjacent to the electron blocking layer EBL, but such is not required, and the one hole transport auxiliary layer having the highest HOMO energy level among the three or more hole transport auxiliary layers can be interposed between the other two hole transport auxiliary layers. When three or more hole transport auxiliary layers are provided between the hole transport layer and the electron blocking layer, one hole transport auxiliary layer having the smallest thickness among the three or more hole transport auxiliary layers can be located immediately adjacent to the electron blocking layer EBL. When three or more hole transport auxiliary layers are provided, the HOMO energy levels of the three or more hole transport auxiliary layers can be different or at least two of the hole transport auxiliary layers can be the same or about the same.

With reference to FIG. 3, in addition to the description above, a HOMO energy level of the hole transport layer HTL can be higher than the HOMO energy level of the first hole transport auxiliary layer P1, and the HOMO energy level of the first hole transport auxiliary layer P1 can be lower than the HOMO energy level of the second hole transport auxiliary layer P2, while the HOMO energy level of the second hole transport auxiliary layer P2 can be higher than the HOMO energy level of the electron blocking layer EBL. Additionally, the HOMO energy level of the electron blocking layer EBL can be lower than the HOMO energy level of the light emitting layer EML. Finally, the HOMO energy level of the light emitting layer EML can be higher than the HOMO energy level of the hole blocking layer HBL, while the HOMO energy level of the hole blocking layer HBL can be about the same as the HOMO energy level of the electron transport layer ETL. But such is not required. In some embodiment, HOMO energy levels of the light emitting layer EML, the hole blocking layer HBL and the electron transport layer ETL can be different from the embodiment of FIG. 3.

In embodiments of the present disclosure, the HOMO energy level of the second hole transport auxiliary layer P2 can be a highest among those of the hole transport layer HTL, the first hole transport auxiliary layer P1, the second hole transport auxiliary layer P2, the electron blocking layer EBL, the light emitting layer EML, the hole blocking layer HBL and the electron transport layer ETL, but such is not required, and one or more of the layers other than the first hole transport auxiliary layer P1 and the electron blocking layer EBL can have the HOMO energy level that is not lower than that of the second hole transport auxiliary layer P2 as long as the HOMO energy level of the second hole transport auxiliary layer P2 is higher than those of the first hole transport auxiliary layer P1 and the electron blocking layer EBL.

With further reference to FIG. 3, a LUMO energy level of the hole transport layer HTL can be lower than the LUMO energy level of the first hole transport auxiliary layer P1, and the LUMO energy level of the first hole transport auxiliary layer P1 can be higher than the LUMO energy level of the second hole transport auxiliary layer P2, while the LUMO energy level of the second hole transport auxiliary layer P2 can be higher than the LUMO energy level of the electron blocking layer EBL. Additionally, the LUMO energy level of the electron blocking layer EBL can be higher than the LUMO energy level of the light emitting layer EML. Finally, the LUMO energy level of the light emitting layer EML can be lower than the LUMO energy level of the hole blocking layer HBL, while the LUMO energy level of the hole blocking layer HBL can be higher than the LUMO energy level of the electron transport layer ETL.

In embodiments of the present disclosure, the LUMO energy level of the first hole transport auxiliary layer P1 can be a highest among those of the hole transport layer HTL, the first hole transport auxiliary layer P1, the second hole transport auxiliary layer P2, the electron blocking layer EBL, the light emitting layer EML, the hole blocking layer HBL and the electron transport layer ETL, but such is not required, and one or more of the layers other than the light emitting layer EML can have the LUMO energy level that is higher than that of the first hole transport auxiliary layer P1 as long as the LUMO energy level of the light emitting layer EML lower than those of the other layers.

Also, with reference to FIG. 3, the energy band gap of the hole transport layer HTL can be smaller than the energy band gap of the first hole transport auxiliary layer P1, and the energy band gap of the first hole transport auxiliary layer P1 can be greater than the energy band gap of the second hole transport auxiliary layer P2, while the energy band gap of the second hole transport auxiliary layer P2 can be smaller than the energy band gap of the electron blocking layer EBL. Additionally, the energy band gap of the electron blocking layer EBL can be greater than the energy band gap of the light emitting layer EML. Finally, the energy band gap of the light emitting layer EML can be smaller than the energy band gap of the hole blocking layer HBL, while the energy band gap of the hole blocking layer HBL can be greater than the energy band gap of the electron transport layer ETL.

In embodiments of the present disclosure, the energy band gap of the light emitting layer EML can be the smallest among those of the hole transport layer HTL, the first hole transport auxiliary layer P1, the second hole transport auxiliary layer P2, the electron blocking layer EBL, the light emitting layer EML, the hole blocking layer HBL, and the electron transport layer ETL, but such is not required, and one or more of the layers other than the light emitting layer EML can have the energy band gap that are different from those described above as long as the energy band gap of the light emitting layer EML smaller than those of the other layers.

Meanwhile, the hole injection layer HIL and the electron injection layer EIL are shown as omitted in FIG. 3. The hole injection layer HIL and the electron injection layer EIL are very thin layers that contact the first electrode AND and the second electrode CAT, respectively, function to inject holes and electrons, and do not act as an obstacle to the discharge of the light emitting device.

Meanwhile, among the components of the light emitting device ED1 of FIG. 2, the CPL on the second electrode CAT functions as a capping layer to increase the light emission efficiency of light emitted from the light emitting device and protect the light emitting device.

The capping layer CPL can include a plurality of layers having different refractive indices to increase the light emission effect.

Hereinafter, a light emitting display device according to one embodiment of the present disclosure will be described.

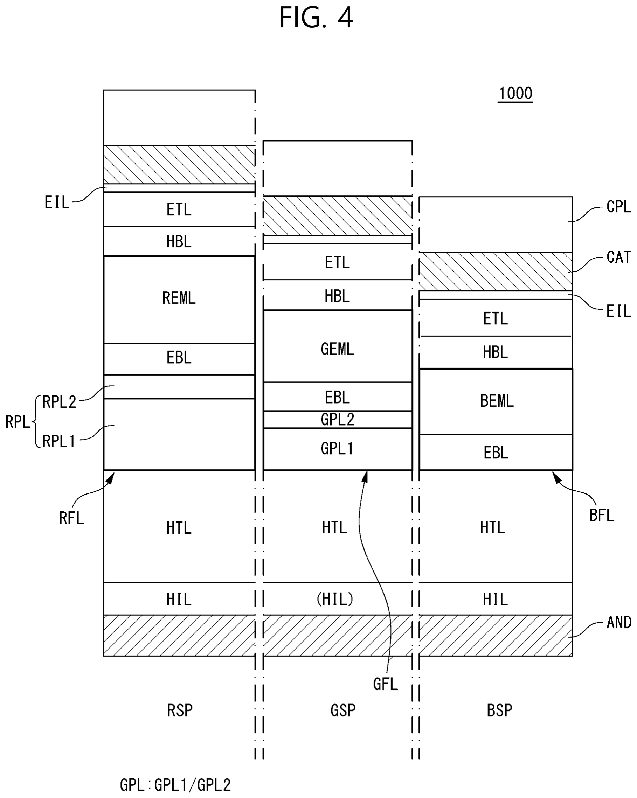

FIG. 4 is a cross-sectional view illustrating light emitting devices of subpixels of a light emitting display device according to one embodiment of the present disclosure.

As shown in FIG. 4, the light emitting display device according to one embodiment of the present disclosure includes a red subpixel RSP, a green subpixel GSP, and a blue subpixel BSP, and the subpixels RSP, GSP, and BSP can have different stacking configurations because different resonance characteristics are required for color of emitted light.

The light emitting display device can include a hole transport auxiliary layer RPL or GPL depending on the wavelength of color of emitted light.

For example, in the wavelength range of visible light, the red wavelength is the longest and the blue wavelength is the shortest. Therefore, the thickness of the red hole transport auxiliary layer RPL of the red subpixel RSP can be greater than that of the green hole transport auxiliary layer GPL of the green subpixel GSP, but are not limited thereto.

The example illustrated in FIG. 4 has a configuration in which the blue subpixel BSP does not have a hole transport auxiliary layer, but the embodiment of the present disclosure is not limited thereto. For example, a blue hole transport auxiliary layer with a thickness smaller than a green hole transport auxiliary layer GPL of a green subpixel GSP can be provided in a blue subpixel.

The above-described example shows a case in which the red light emitting layer REML, the green light emitting layer GEML, and the blue light emitting layer BEML have vertical positions corresponding to resonance conditions in the same order, but the embodiment of the present disclosure is not limited thereto. For example, when the red light emitting layer REML has a vertical position in the first order and the green light emitting layer GEML has a vertical position in the second order, the green hole transport auxiliary layer GPL disposed in the green subpixel GSP can be thicker than the red hole transport auxiliary layer RPL disposed in the red subpixel RSP.

Specifically, the light emitting display device 1000 according to the embodiment shown in FIG. 4 includes a first electrode AND provided in each of the red, green, and blue subpixels RSP, GSP, and BSP, a hole transport common layer CML1 provided on the first electrode AND over the red, green, and blue subpixels RSP, GSP, and BSP, a red light emitting layer REML, a green light emitting layer GEML, and a blue light emitting layer BEML provided on the hole transport common layer CML1 over the red, green, and blue subpixels RSP, GSP, and BSP, an electron transport common layer CML2 provided on the red light emitting layer REML, the green light emitting layer GEML, and the blue light emitting layer BEML over the red, green, and blue subpixels RSP, GSP, and BSP, and a second electrode CAT provided on the electron transport common layer CML2.

A capping layer CPL is provided on the second electrode CAT to enhance the light emitting effect of the light emitting device RED, GED, or BED of each subpixel RSP, GSP or BSP.

The light emitting display device 1000 according to the embodiment of the present disclosure can include optional layers RFL, GFL, and BFL in addition to the hole transport common layer CML1 and the electron transport common layer CML2 in the respective subpixels.

For example, the green optional layer GFL provided at the green subpixel GSP can include a first hole transport auxiliary layer GPL1, a second hole transport auxiliary layer GPL2, an electron blocking layer EBL, and a green light emitting layer GEML sequentially provided between the hole transport common layer CML1 and the electron transport common layer CML2.

The red optional layer RFL provided at the red subpixel RSP can include a third hole transport auxiliary layer RPL1, a fourth hole transport auxiliary layer RPL2, an electron blocking layer EBL, and a red light emitting layer REML sequentially provided between the hole transport common layer CML1 and the electron transport common layer CML2.

The blue optional layer BFL provided at the blue subpixel BSP can include an electron blocking layer EBL and a blue light emitting layer BEML sequentially provided between the hole transport common layer CML1 and the electron transport common layer CML2.

Meanwhile, in the above-described example, the red optional layer RFL, the green optional layer GFL, and the blue optional layer BFL include a common electron blocking layer EBL. The electron blocking layer EBL can be provided commonly over the red subpixel RSP, the green subpixel GSP, and the blue subpixel BSP, or can be formed separately for each subpixel RSP, GSP, BSP. When the electron blocking layer EBL is provided for each subpixel RSP, GSP or BSP, each of them can be patterned using the same deposition mask as the hole transport auxiliary layer disposed thereunder or the light emitting layer disposed thereon, and the number of deposition masks in the process can be reduced.

In the example illustrated in FIG. 4, a green hole transport auxiliary layer GPL including first and second hole transport auxiliary layers GPL1 and GPL2 is provided in a green subpixel GSP, a red hole transport auxiliary layer RPL including third and fourth hole transport auxiliary layers RPL1 and RPL2 is provided in a red subpixel RSP, and a hole transport auxiliary layer is not provided in a blue subpixel BSP.

However, the light emitting display device of the embodiment of the present disclosure is not limited thereto. For example, a hole transport auxiliary layer can be further provided between the hole transport common layer CML1 and the electron blocking layer EBL in the blue subpixel BSP. The hole transport auxiliary layer provided in the blue subpixel BSP can have a thickness less than the hole transport auxiliary layers GPL and RPL provided in the green subpixel GSP and the red subpixel RSP. In some cases, when the hole transport auxiliary layer is provided in the blue subpixel BSP, it can be formed of the same material or have the same thickness as one of the first to fourth hole transport auxiliary layers GPL1, GPL2, RPL1, and RPL2.

The first hole transport auxiliary layer GPL1 provided at the green subpixel GSP adjusts the vertical position so that the green light emitting layer GEML at the green subpixel GSP optimally resonates between the first and second electrodes AND and CAT, and the third hole transport auxiliary layer RPL1 provided in the red subpixel RSP adjusts the vertical position so that the red light emitting layer REML at the red subpixel RSP optimally resonates between the first and second electrodes AND and CAT. The thicknesses of the first and third hole transport auxiliary layers GPL1 and RPL1 can be proportional to the green emission wavelength and the red emission wavelength, respectively. In addition, the thicknesses of the first and third hole transport auxiliary layers GPL1 and RPL1 are changed depending on the color coordinates corresponding to the green emission wavelength and the red emission wavelength, respectively.

The thickness of the third hole transport auxiliary layer RPL1 can be greater than that of the first hole transport auxiliary layer GPL1.

The second hole transport auxiliary layer GPL2 provided in the green subpixel GSP can have a HOMO energy level higher than the HOMO energy level of each of the first hole transport auxiliary layer GPL1 and the electron blocking layer EBL located on both or opposite sides of the second hole transport auxiliary layer GPL2.

Meanwhile, the first hole transport auxiliary layer GPL1 can be provided by co-depositing a material for the second hole transport auxiliary layer GPL2 with a material for the electron blocking layer EBL.

The green light emitting device GED has high luminance efficiency and excellent visibility compared to other color light emitting devices. Therefore, the arrangement density of the green light emitting device among the red, green, and blue light emitting devices in the light emitting display device can be greatly increased. When a single-layer hole transport auxiliary layer is provided for color coordinate correspondence in the green subpixel in a light emitting display device having a difference in the arrangement density between the green light emitting device and the other color light emitting device, a green color tone can be observed prominently in the first frame response FFR driven at low grayscale.

The first frame response FFR of the light emitting display device is related to various factors such as the arrangement of thin film transistors and red, green, and blue subpixels, the driving method, and the compensation algorithm. Among them, in terms of light emitting devices, green light was observed prominently in the panel in the low grayscale state. This is because the electrostatic capacitance of the green light emitting device is greater than that of the other color light emitting devices.

The light emitting display device according to the embodiment of the present disclosure includes first and second hole transport auxiliary layers GPL1 and GPL2 having HOMO energy level differences in the structure of the green hole transport auxiliary layer GPL in the green subpixel GSP, thereby reducing the electrostatic capacitance of the green light emitting device. As a result, it is possible to adjust the electrostatic capacitance of the green light emitting device similar to the red light emitting device and the blue light emitting device in the initial state, and prevent a specific color from being prominent.

The light emitting display device according to the embodiment of the present disclosure includes a second hole transport auxiliary layer GPL2 having a high HOMO energy level that assists hole discharge in addition to the first hole transport auxiliary layer GPL1 for color coordinate adjustment in the hole transport auxiliary layer GPL in at least the green subpixel GSP, so as to prevent low-grayscale color deviation of green. As a result, the light emitting display device according to the embodiment of the present disclosure can improve the discharge effect in the low-grayscale or off state.

The proportion of the green light emitting device greatly contributes to express white in the light emitting display device, the holes present at the interface between the light emitting layer and the electron blocking layer in the off state in the green subpixel are quickly moved through the electron blocking layer EBL due to the large surface potential characteristic of the second hole transport auxiliary layer GPL2, and the holes are temporarily accumulated due to the high HOMO energy level of the second hole transport auxiliary layer GPL2, so that leakage caused by the residual holes at the light emitting layer interface at low grayscale can be effectively prevented.

In addition, the light emitting display device according to the embodiment of the present disclosure can secure energy balance between the red, green, and blue light emitting devices by reducing the initial electrostatic capacity of the green light emitting device with high luminance efficiency. In addition, the light emitting display device can prevent the defect in which a specific color is observed at the low grayscale state of the light emitting display device.

Meanwhile, FIG. 4 has a configuration in which third and fourth hole transport auxiliary layers RPL1 and RPL2 having HOMO energy level differences are provided in the structure of the red hole transport auxiliary layer RPL in the red subpixel RSP, thereby enhancing the discharge effect in the off state of the red light emitting device and preventing light leakage in the low-grayscale state.

The third hole transport auxiliary layer RPL1 adjusts the vertical position of the red light emitting layer REML to correspond to the color coordinate of red, which can be proportional to the red wavelength. The third hole transport auxiliary layer RPL1 can have a thickness greater than that of the first hole transport auxiliary layer GPL1 planarly adjacent thereto.

The fourth hole transport auxiliary layer RPL2 is provided between the third hole transport auxiliary layer RPL1 and the electron blocking layer EBL for the discharge effect of holes. The fourth hole transport auxiliary layer RPL2 can have a thickness smaller than that of the second hole transport auxiliary layer GPL2.

Meanwhile, the third hole transport auxiliary layer RPL1 can also be prepared by co-depositing the material for the second hole transport auxiliary layer GPL2 and the material for the electron blocking layer EBL.

The second hole transport auxiliary layer GPL2 rapidly receives and accumulates holes from the green light emitting layer GEML through the electron blocking layer EBL in the off state or low-grayscale state. For this purpose, the second hole transport auxiliary layer GPL2 has a HOMO energy level higher than the HOMO energy level of the electron blocking layer EBL directly in contact with the second hole transport auxiliary layer GPL2 and also has a HOMO energy level higher than the HOMO energy level of the adjacent green light emitting layer GEML.

Similarly, the fourth hole transport auxiliary layer RPL2 rapidly receives and accumulates holes from the red light emitting layer REML through the electron blocking layer in the off state or low-grayscale state. For this purpose, the fourth hole transport auxiliary layer RPL2 has a HOMO energy level higher than the HOMO energy level of the adjacent electron blocking layer EBL and a HOMO energy level higher than the HOMO energy level of the adjacent red light emitting layer REML.

In addition, the green light emitting layer has a green host GH and a green dopant GD, and the HOMO energy level of the green light emitting layer depends on the HOMO of the green host included as the main content. The red light emitting layer has a red host RH and a red dopant RD, and the HOMO energy level of the red light emitting layer depends on the HOMO of the red host included as the main content.

The HOMO energy level of the red light emitting layer is different from the HOMO energy level of the green light emitting layer. Accordingly, the HOMO energy levels of the fourth hole transport auxiliary layer RPL2 and the second hole transport auxiliary layer GPL2 having a higher HOMO energy level than the red or green light emitting layer can also be different.

Meanwhile, the first hole transport auxiliary layer GPL1 can include, for example, any one of TAPC (1,1-bis[(di-4-tolylamino)phenyl]cyclohexane), NPB (N,N'-di(1-naphthyl)-N'N'-diphenyl-(1,1'-biphenyl)-4,4'-diamine), TCTA (tris(4-carbazoyl-9-ylphenyl)amine), or CBP (4,4'-bis(N-carbazolyl)-1,1'-biphenyl), but is not limited thereto.

The second hole transport auxiliary layer GPL2 has optical properties similar to those of the first hole transport auxiliary layer GPL1, but can include an electron-donating group in the compound structure to increase the HOMO energy level. The second hole transport auxiliary layer GPL2 can be formed of a compound including a unit of a hole transport material that is the same as or similar to that of the first hole transport auxiliary layer GPL1 and an electron-donating group.

For example, the electron-donating group can be triphenylamine, carbazole, fluorine, thiophene, methoxy (-OCH₃), an alkyl group, or the like, but is not limited thereto.

As another example, the first hole transport auxiliary layer GPL1 can further include an electron-withdrawing group in the compound to lower the HOMO energy level so as to increase the HOMO energy level differences with the second hole transport auxiliary layer GPL2.

For example, examples of the electron-withdrawing group can include a cyano group (-CN), a trifluoromethyl group (-CF3), pyridine, oxadiazole, triazine, benzothiadiazole, and the like, but is not limited thereto.

In addition, examples of the third hole transport auxiliary layer RPL1 can include TCTA (tris(4-carbazoyl-9-ylphenyl)amine), CBP (4,4'-bis(N-carbazolyl)-1,1'-biphenyl), NPD (N,N-di(1-naphthyl)-N,N'-diphenylbenzidine), FLU-DTPA (N1-(9,9-diphenyl-9H-fluoren-2-yl)-N1-(4-(diphenylamino)phenyl)-N4,N4-diphenylbenzene-1,4-diamine), FLU-DCAR (N,N-bis(4-(9H-carbazol-9-yl)phenyl)-9,9-diphenyl-9H-fluoren-2-amine), and the like, but is not limited thereto.

The fourth hole transport auxiliary layer RPL2 has optically similar properties to the third hole transport auxiliary layer RPL1, but can include an electron-donating group in the compound structure so as to increase the HOMO energy level. The fourth hole transport auxiliary layer RPL2 can be formed of a compound including a unit of a hole transport material that is the same as or similar to the third hole transport auxiliary layer RPL1 and an electron-donating group.

However, the embodiments of the present disclosure are not limited thereto. The materials can be changed as long as the HOMO energy level relationship of the hole transport layer, the first and second hole transport auxiliary layers GPL1 and GPL2, the electron blocking layer, and the green light emitting layer GEML satisfies the requirements described above.

Hereinafter, the effect of the structure using a plurality of hole transport layers of the present disclosure will be described based on experiments.

First, Experimental Example (EX1) in which the green hole transport auxiliary layer GPL of the green light emitting device is used as a single optical compensation layer, and Experimental Example 2 and 3 (EX2 and EX3) in which a laminate of the first and second hole transport auxiliary layers GPL1 and GPL2 is used as a single optical compensation layer will be described.

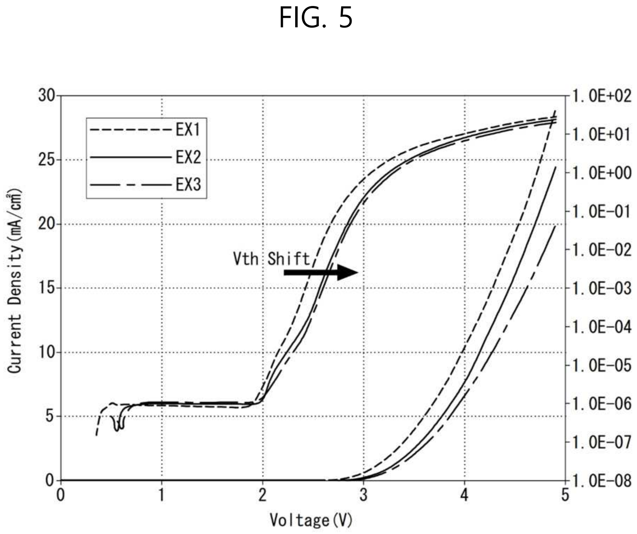

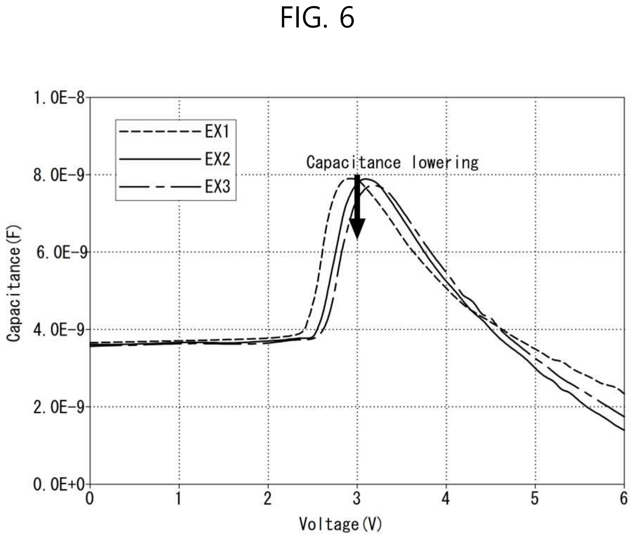

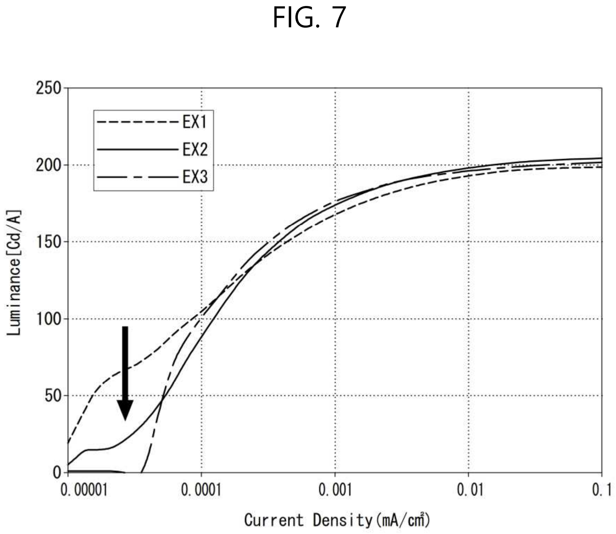

FIG. 5 is a graph showing the JV characteristics of the green light emitting device of FIG. 4. FIG. 6 is a graph showing the CV characteristics of the green light emitting device of FIG. 4. FIG. 7 is a graph showing the luminance characteristics depending on the current density of the green light emitting device of FIG. 4.

Table 1 shows the HOMO energy level, LUMO energy level, triplet energy level T, and energy band gap Eg of the hole transport layer HTL, the first hole transport auxiliary layer GPL1, the second hole transport auxiliary layer GPL2, the electron blocking layer EBL, the green dopant GD of the green light emitting layer, and the green host GH of the green light emitting layer in the green light emitting device used in the experimental examples.

**[Table 1]**

| Material | HOMO (eV) | LUMO (eV) | T (eV) | Eg (eV) |
|---|---|---|---|---|
| HTL | -5.57 | -2.41 | 2.65 | 3.16 |
| GPL1 | -5.67 | -2.03 | 2.51 | 3.64 |
| GPL2 | -5.29 | -2.06 | 2.53 | 3.23 |
| EBL | -5.79 | -2.11 | 2.54 | 3.68 |
| GD | -5.60 | -2.70 | 2.80 | 2.90 |
| GH | -5.61 | -3.35 | 2.61 | 2.26 |

In the green light emitting device GED, the first hole transport auxiliary layer GPL1 has a HOMO energy level difference of 0.15 eV or less from the adjacent hole transport layer HTL and has a higher hole mobility than the second hole transport auxiliary layer GPL2. The first hole transport auxiliary layer GPL1 has a thickness T1 that is suitable for the color coordinate characteristics of the green light emitting device. For example, the thickness of the first hole transport auxiliary layer GPL1 is 200Å to 700Å, but is not limited thereto.

The second hole transport auxiliary layer GPL2 has a HOMO energy level higher than -5.3 eV and the absolute value of the HOMO energy level is 5.3 eV or less. The second hole transport auxiliary layer GPL2 has a HOMO energy level difference of 0.25 eV or more from the adjacent electron blocking layer EBL. The second hole transport auxiliary layer GPL2 can contribute to hole discharge in the off state or low-grayscale state and can have a thickness of 1/30 to 1/3 of the thickness of the first hole transport auxiliary layer GPL1. Preferably, the thickness of the second hole transport auxiliary layer GPL2 can be 30Å to 70Å.

**[Table 2]**

| Item | Thickness | | Device characteristics | | | | Module performance |
|---|---|---|---|---|---|---|---|
| | GPL1 | GPL2[Å] | ΔVth[V] | ΔV[V] | Eff(%) | LT(%) | FFR(dY) |
| EX1 | T1 | - | Vt | Vd | 100.0 | 100 | - |
| EX2 | T1 | 30 | Vt+0.12 | Vd+0.11 | 101.9 | 95 | +4.2% |
| EX3 | T1 | 50 | Vt+0.22 | Vd+0.15 | 101.5 | 100 | +7.4% |

Experimental Examples 1 to 3 (EX1, EX2, and EX3) include materials having the physical properties of the hole transport layer, the first and second hole transport auxiliary layers, the electron blocking layer, and the green light emitting layer in Table 1.

In Experimental Example 1 (EX1), the green hole transport auxiliary layer GPL was a single first hole transport auxiliary layer GPL1 having a thickness of T1.

In Experimental Example 2 and 3 (EX2 and EX3), the hole transport auxiliary layer was formed as a laminated structure of the first and second hole transport auxiliary layers GPL1 and GPL2, but the thickness of the second hole transport auxiliary layer GPL2 was changed to 30Å and 50Å, respectively.

As can be seen from J-V graphs in Table 2 and FIG. 5, the voltage for providing the same current density gradually increases in Experimental Example 2 and 3 (EX2 and EX3), compared to Experimental Example 1 (EX1). This means that the threshold voltage to obtain a predetermined current density in Experimental Examples 2 and 3 (EX2 and EX3) is higher than that in Experimental Example 1 (EX1) and that leakage is reduced or prevented in the low-grayscale state.

As can be seen from the C-V graph of FIG. 6, the driving voltage causing a predetermined change in electrostatic capacity is higher in Experimental Examples 2 and 3 (EX2 and EX3) compared to Experimental Example 1 (EX1). This means that the light emitting devices of Experimental Example 2 and 3 (EX2 and EX3) secure an initial electrostatic capacity of a predetermined level or higher and thus there is no leakage in the low-grayscale state or the off state.

As can be seen from the graph showing the efficiency as a function of the current density of FIG. 7, Experimental Examples 2 and 3 (EX2 and EX3) exhibit low luminance at a low-grayscale current density of 0.00001 to 0.0001 mA/cm².

Table 2 shows the efficiency (Eff(%)) compared to Experimental Example 1 (EX1) at a current density of 10 mA/cm², which means that the efficiency of Experimental Examples 2 and 3 (EX2 and EX3) actually increase at a current density (10 mA/cm²) during normal operation.

In addition, the numerical value indicating the module performance FFR is a color coordinate change of Experimental Examples 2 and 3 (EX2 and EX3) compared to Experimental Example 1 (EX1). As the value increases, the low-grayscale efficiency decreases.

In addition, as can be seen from Table 2, Experimental Example 1 (EX1) and Experimental Example 3 (EX3) exhibit similar lifespan (LT(%)) of the light emitting device. Experimental Example 2 (EX2) has a reduced lifespan, but has effects of relatively increasing the threshold voltage of the light emitting device, of increasing the efficiency during operation, and of reducing the low-grayscale efficiency, compared to Experimental Example 1 (EX1), thus being superior to Experimental Example 1 (EX1) in terms of optical characteristics.

The results of Experimental Example 3 (EX3) in Table 2 show that, when the thickness of the second hole transport auxiliary layer GPL2 is 50Å or more in the embodiment of the present disclosure, effects of preventing low-grayscale leakage light, of stabilizing driving characteristics, and of providing efficient discharge in the off state are obtained.

Hereinafter, the effects of experimental examples will be described compared to the structure of Experimental Example 3 (EX3) according to the embodiment of the present disclosure by changing the material for the second hole transport auxiliary layer or the material for the electron blocking layer in the structure of the green light emitting device.

**[Table 3]**

| Item | Thickness | | | Device characteristics | | | | Module performance |
|---|---|---|---|---|---|---|---|---|
| | GPL1 | GPL2[Å] | EBL | ΔVth[V] | ΔV[V] | Eff(%) | LT(%) | FFR(dY) |
| EX1 | T1 | - | EBLA | Vt | Vd | 100.0 | 100 | - |
| EX3(GPL2) | T1 | 50 | | Vt+0.22 | Vd+0.15 | 101.5 | 100 | +7.4% |
| EX4(GPL2A) | T1 | 50 | | Vt+0.11 | Vd+0.12 | 98.8 | 98 | 0.5% |
| EX5(GPL2B) | T1 | 50 | | Vt+0.10 | Vd+0.12 | 99.2 | 101 | 0.2% |
| EX6(GPL2) | T1 | 50 | EBLB | Vt+0.06 | Vd+0.10 | 99.5 | 93 | 1.1% |

In Experimental Examples 4 and 5 (EX4 and EX5), the HOMO energy levels of the materials for the second hole transport auxiliary layer GPL2A or GPL2B are lower than -5.3 eV, compared to Experimental Example 3 (EX3). The HOMO energy level of the second hole transport auxiliary layer material GPL2A of Experimental Example 4 (EX4) is closer to the HOMO energy level of the electron blocking layer EBL than the HOMO energy level of the second hole transport auxiliary layer material GPL2B of Experimental Example 5 (EX5).

In Experimental Example 6 (EX6), the second hole transport auxiliary layer GPL2 is formed using the same material as in Experimental Example 3 (EX3), but the electron blocking layer material adjacent to the second hole transport auxiliary layer GPL2 is different, and the HOMO energy level between the electron blocking layer and the second hole transport auxiliary layer GPL2 is set to 0.25 eV or less.

Upon the changes in Experimental Examples 3 to 6 (EX3, EX4, EX5, and EX6), Experimental Example 3 (EX3) exhibits the best low-grayscale efficiency reduction effect. In particular, it was found that, when a green light emitting device was applied to Experimental Example 3 (EX3) in the light emitting display device according to the embodiment of the present disclosure, the threshold voltage of the green light emitting device was increased, the efficiency during operation was improved, and the lifespan was stabilized. In addition, the phenomenon in which green is prominent can be prevented by lowering the efficiency of green at low grayscales. In addition, the discharge effect in the off state can also be improved.

Hereinafter, Experimental Example 7 (EX7) in which the red hole transport auxiliary layer RPL of the red light emitting device is applied as a single optical compensation layer, and Experimental Examples 8 and 9 (EX8 and EX9) in which the third and fourth hole transport auxiliary layers RPL1 and RPL2 are laminated will be described.

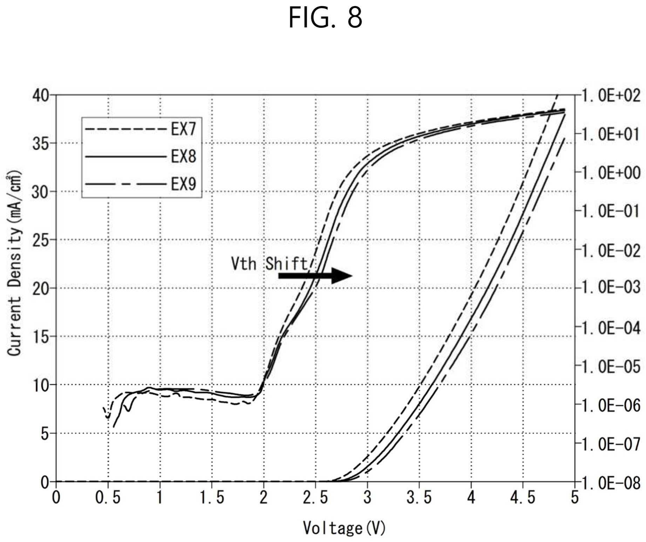

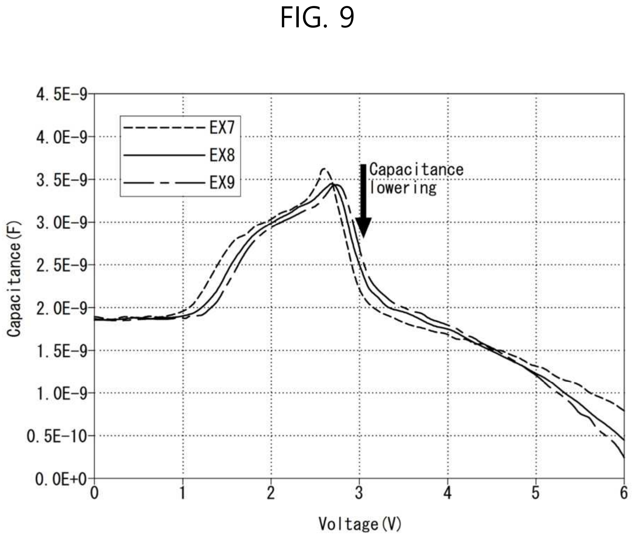

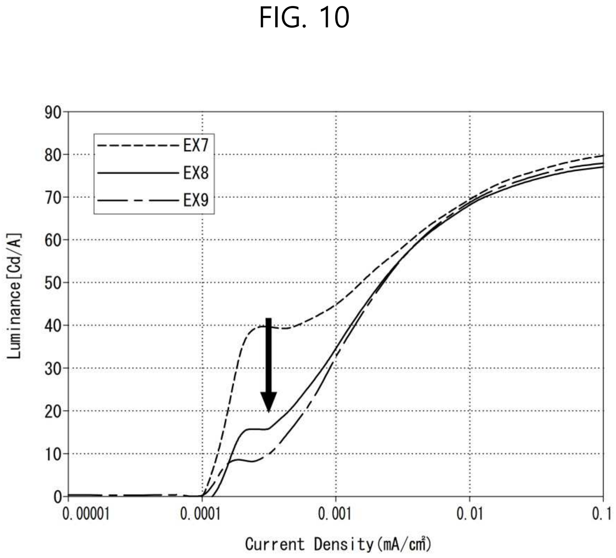

FIG. 8 is a graph showing the JV characteristics of the light emitting device of the red subpixel of FIG. 4. FIG. 9 is a graph showing the CV characteristics of the light emitting device of the red subpixel of FIG. 4. FIG. 10 is a graph showing the luminance characteristics as a function of current density of the light emitting device of the red subpixel of FIG. 4.

Table 4 shows the HOMO energy level, LUMO energy level, triplet energy level T, and energy band gap Eg of the hole transport layer HTL, the third hole transport auxiliary layer RPL1, the fourth hole transport auxiliary layer RPL2, the electron blocking layer EBL, the red dopant RD of the red light emitting layer, and the red host RH of the red light emitting layer in the red light emitting devices used in Experimental Examples 7 to 9 (EX7, EX8 and EX9).

**[Table 4]**

| Material | HOMO (eV) | LUMO (eV) | T (eV) | Eg (eV) |
|---|---|---|---|---|
| HTL | -5.57 | -2.41 | 2.65 | 3.16 |
| RPL1 | -5.68 | -2.04 | 2.35 | 3.64 |
| RPL2 | -5.50 | -2.13 | 2.39 | 3.37 |
| EBL | -5.79 | -2.11 | 2.54 | 3.68 |
| RD | -5.60 | -3.20 | 2.10 | 2.40 |
| RH | -5.72 | -2.92 | 2.37 | 2.80 |

In the red light emitting device RED, the third hole transport auxiliary layer RPL1 has a HOMO energy level difference of 0.15 eV or less from the adjacent hole transport layer HTL and has a higher hole mobility than the fourth hole transport auxiliary layer RPL2.

The third hole transport auxiliary layer RPL1 has a thickness T2 that is suitable for the color coordinate characteristics of the red light emitting device. For example, the thickness of the third hole transport auxiliary layer RPL1 is 200Å to 1200Å, but is not limited thereto.

The fourth hole transport auxiliary layer RPL2 has a HOMO energy level higher than -5.6 eV and the absolute value of the HOMO energy level is 5.6 eV or less. The fourth hole transport auxiliary layer RPL2 has a HOMO energy level difference of 0.15 eV or more from the adjacent electron blocking layer EBL. The fourth hole transport auxiliary layer RPL2 contributes to the hole discharge in the off state or low-level state, and the thickness thereof can be 1/30 to 1/3 of the thickness of the third hole transport auxiliary layer RPL1. Preferably, the thickness of the fourth hole transport auxiliary layer RPL2 can be 30Å to 50Å.

**[Table 5]**

| Item | Thickness | | Device characteristics | | | | Module performance |
|---|---|---|---|---|---|---|---|
| | RPL1 | RPL2[Å] | ΔVth[V] | ΔV[V] | Eff(%) | LT(%) | FFR(dY) |
| EX7 | T2 | - | Vtr | Vdr | 100.0 | 100 | - |
| EX8 | T2 | 30 | Vtr+0.08 | Vdr+0.12 | 101.5 | 100 | +4.6% |
| EX9 | T2 | 50 | Vtr+0.15 | Vdr+0.20 | 101.8 | 103 | +2.4% |

Experimental Examples 7 to 9 (EX7, EX8, and EX9) include materials having the physical properties of the hole transport layer, the third and fourth hole transport auxiliary layers, the electron blocking layer, and the red light emitting layer in Table 4.

In Experimental Example 7 (EX7), the red hole transport auxiliary layer RPL was formed as a single third hole transport auxiliary layer RPL1 having a thickness of T2.

In Experimental Examples 8 and 9 (EX8 and EX9), the hole transport auxiliary layer was formed as a laminated structure of the third and fourth hole transport auxiliary layers RPL1 and RPL2, but the thickness of the fourth hole transport auxiliary layer RPL2 was changed to 30Å and 50Å, respectively.

As can be seen from Table 5 and the J-V graph of FIG. 8, the voltage for providing the same current density gradually increases in Experimental Examples 8 and 9 (EX8 and EX9), compared to Experimental Example 7 (EX7). This means that the threshold voltage to provide a predetermined current density or higher in Experimental Examples 8 and 9 (EX8 and EX9) is higher than that in Experimental Example 7 (EX7), and that leakage is reduced or prevented in the low-grayscale state.

As can be seen from the C-V graph of FIG. 9, the driving voltage causing a predetermined or higher of change in electrostatic capacity is relatively higher in Experimental examples 8 and 9 (EX8 and EX9), compared to Experimental Example 7 (EX7). This means that the light emitting devices of Experimental Examples 8 and 9 (EX8 and EX9) secure an initial electrostatic capacity or higher and thus there is no leakage in the low-grayscale state or the off state.

As can be seen from the graph of FIG. 10, showing the efficiency as a function of current density, the luminance is lowered at a low-grayscale current density of 0.0001 to 0.001 mA/cm² in Experimental Examples 8 and 9 (EX8 and EX9).

Table 5 shows the efficiency (Eff(%)) compared to Experimental Example 7 (EX7) at a current density of 10 mA/cm², and that Experimental Examples 8 and 9 (EX8 and EX9) actually had higher efficiency at a current density (10 mA/cm²) during normal operation.

In addition, the numerical value indicating the module performance FFR is the color coordinate CIE and the numerical value of Experimental Example 7 (EX7) is lower than that of each of Experimental Examples 8 and 9 (EX8 and EX9). As the value increases, the low-grayscale efficiency decreases. It can be seen that Experimental Example 8 (EX8) has better FFR characteristics than Experimental Example 9 (EX9).

It can be seen that Experimental Example 3 (EX3) for the green light emitting device and Experimental Example 8 (EX8) for the red light emitting device, when the green light emitting device and the red light emitting device are adjacently disposed, exhibit similar FFR values.

For example, the thickness of the second hole transport auxiliary layer GPL2 in the green light emitting device can be different from the thickness of the fourth hole transport auxiliary layer RPL2 in the red light emitting device. By adjusting the thickness of the second hole transport auxiliary layer GPL2 to be greater than the thickness of the fourth hole transport auxiliary layer RPL2, the balance between the low-grayscale efficiency of the red subpixel and the low-grayscale efficiency of the green subpixel can be achieved.

In addition, as can be seen from Table 5, Experimental Example 7 (EX7) exhibits similar lifespan (LT(%)) of the light emitting device and Experimental Example 8 (EX8) and Experimental Example 9 (EX9) exhibits improved lifespan (LT(%)) of the light emitting device, compared to Experimental Examples 7 and 8 (EX7 and EX8).

The results of Experimental Examples 8 and 9 (EX8 and EX9) in Table 5 show that, when the thickness of the fourth hole transport auxiliary layer RPL2 is 30Å to 50Å in the embodiment of the present disclosure, effects of preventing low-grayscale leakage light, of stabilizing the driving characteristics, and of providing efficient discharge in the off state are obtained.

The light emitting device and light emitting display device according to the embodiment of the present disclosure can prevent the occurrence of low-grayscale leakage light due to the potential increase of the first electrode caused by the residual charge between the electron blocking layer and the light emitting layer in at least the green subpixel.

At least the hole transport auxiliary layer of the green subpixel is formed as a stacked structure of first and second hole transport auxiliary layers having different HOMO energy levels, so that the second hole transport auxiliary layer serves as a well layer between the first hole transport auxiliary layer and the electron blocking layer to temporarily accumulate holes and change the position where the residual charge remains between the electron blocking layer and the light emitting layer, thereby solving the low-grayscale leakage light issue. Accordingly, it is possible to improve the electroluminescent characteristics of the light emitting display device and prevent the prominence of a specific color at low gray levels or light leakage.

Hereinafter, the pixel circuit structure of the light emitting display device according to one embodiment of the present disclosure will be described.

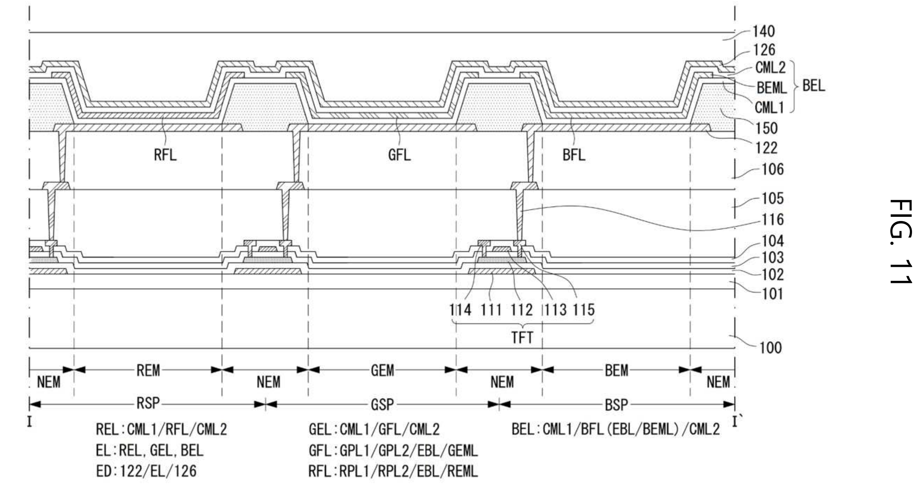

FIG. 11 is a cross-sectional view illustrating a light emitting display device according to one embodiment of the present disclosure.

As shown in FIG. 11, a substrate 100 on which each subpixel RSP, GSP or BSP is disposed can be formed as a single layer or multiple layers.

The substrate 100 can include at least one of a glass substrate, a plastic film, or a metal plate having a predetermined supporting force. The substrate 100 can be formed of a flexible material. For example, when the substrate 100 is formed of multiple layers, it can have a stacked structure of a first organic film, an inorganic insulating layer, and a second organic film. The first organic film on the outermost side can prevent the introduction of external impurities and have a protective function. The second organic film can function to planarize the formation surface of the internal array structure and to prevent charge transfer or impurity transfer from the outside to the inside. The inorganic insulating layer between the first and second organic films can function to prevent diffusion of moisture and impurities between the first and second organic films.

A first insulating film 101 can be provided on the substrate 100. The first insulating film 101 can function as a buffer layer or an active buffer layer. The buffer layer and the active buffer layer can function to prevent impurities from being transferred from the lower side of the wiring and active layer included in the internal array to the upper side and to support and protect the upper components. The first insulating film 101 can have multiple layers.

A thin film transistor TFT and a storage capacitor can be disposed on the first insulating film 101 in each subpixel RSP, GSP, BSP.

A light blocking layer 111 can be provided on the first insulating film 101 to prevent light from being transmitted from below to the active layer 112 of the thin film transistor TFT.

A second insulating film 102 can be disposed between the light blocking layer 111 and the active layer 112 for insulation.

The thin film transistor TFT can be disposed on each of a plurality of subpixels on the second insulating film 102. For example, the thin film transistor TFT can include an active layer 112, a gate electrode 113 overlapping the active layer 112 with a third insulating film 103 interposed therebetween, and a first source/drain electrode 114 and a second source/drain electrode 115 connected to both sides of the active layer 112.

For example, a storage capacitor can include a first storage electrode and a second storage electrode overlapping each other. At least one of the first and second storage electrodes can be formed of the same material as the active layer 112, and the other can include the same material as the gate electrode 113, the first and second source/drain electrodes 114 and 115, and the light blocking layer 111.

The third insulating film 103 between the active layer 112 and the gate electrode 113 can function as a gate insulating film.

The active layer 112 can include, for example, a silicon-based or oxide semiconductor. The silicon-based semiconductor can include crystalline and/or amorphous silicon. The oxide semiconductor can include at least one of gallium oxide, tin oxide, zinc oxide, indium oxide, iron oxide, or indium-gallium-zinc oxide. The oxide semiconductor layer can be formed of multiple layers having different materials or different material composition ratios. Each subpixel can include multiple thin film transistors and the thin film transistors can be disposed on different layers. For example, each subpixel of the substrate 100 can include a plurality of thin film transistors having different active layers. For example, the first thin film transistor can be formed as a silicon-based active layer and can be closer to the substrate 100, and the second thin film transistor can be formed as an oxide semiconductor active layer above the first thin film transistor.

The active layer 112 can include a channel region overlapping the gate electrode 113 and a source/drain region connected to each of the first and second source/drain electrodes 114 and 115.

The third insulating film 103 can be selectively disposed corresponding to the channel region of the active layer 112 and can be provided over the entire surface of the substrate 100 excluding the region through which the first and second source/drain electrodes 114 and 115 penetrate. The third insulating film 103 can function to insulate the active layer 112 from the gate electrode 113. The third insulating film 103 can be formed of an inorganic insulating material and can be formed as, for example, a silicon oxide film (SiOx), a silicon nitride film (SiNx), a silicon oxynitride film (SiOxNy), or a multilayer film thereof, but is not limited thereto.

A gate electrode 113 can be formed on the third insulating film 103. The gate electrode 113 can be disposed to face the active layer 112 with the third insulating film 103 interposed therebetween.

A fourth insulating film 104 can be formed on the gate electrode 113 to cover and protect the gate electrode 113. In addition, the fourth insulating film 104 can function to protect at least one electrode of the thin film transistor TFT and the active layer 112. The fourth insulating film 104 can be formed of an inorganic insulating material. For example, the fourth insulating film 104 can be formed as a silicon oxide film (SiOx), a silicon nitride film (SiNx), a silicon oxynitride film (SiOxNy), or a multilayer film thereof, but is not limited thereto.

A first source/drain electrode 114 and a second source/drain electrode 115 can be disposed on the fourth insulating film 104. The fourth insulating film 104 and the third insulating film 103 can have contact holes to contact the first and second source/drain electrodes 114 and 115 at both ends of the active layer 112 and the corresponding areas can be removed.

The gate electrode 113 and the first and second source/drain electrodes 114 and 115 can each be formed as a single layer or multiple layers.

When the gate electrode 113 and the first and second source/drain electrodes 114 and 115 are single layers, they can be formed of one selected from the group consisting of molybdenum (Mo), aluminum (Al), chromium (Cr), gold (Au), titanium (Ti), nickel (Ni), neodymium (Nd), or copper (Cu), or an alloy thereof. In addition, when the gate electrode 113, and the first and second source/drain electrodes 114 and 115 include multiple layers, they can include double layers of molybdenum/aluminum-neodymium, molybdenum/aluminum, titanium/aluminum, or copper/molytitanium. Alternatively, the gate electrode 113 and the first and second source/drain electrodes 114 and 115 can include triple layers of molybdenum/aluminum-neodymium/molybdenum, molybdenum/aluminum/molybdenum, titanium/aluminum/titanium, or molybdenum/copper/molybdenum.

However, the configuration of the gate electrode 113 and the first and second source/drain electrodes 114 and 115 is not limited thereto, and the gate electrode 113 and the first and second source/drain electrodes 114 and 115 can include multiple layers formed of one selected from the group consisting of molybdenum (Mo), aluminum (Al), chromium (Cr), gold (Au), titanium (Ti), nickel (Ni), neodymium (Nd), or copper (Cu), or an alloy thereof.

The first to fourth insulating films 101, 102, 103 and 104 can each be formed as inorganic insulating films. The inorganic insulating film can be, for example, formed as at least one of a silicon oxide film, a silicon nitride film, or a silicon oxynitride film, but is not limited thereto.

A first planarization film 105 and a second planarization film 106 can be provided on the first to fourth insulating films 101, 102, 103 and 104. The first planarization film 105 can have a contact hole, and a connecting electrode 116 connected to the second source/drain electrode 115 can be provided in the contact hole. The second planarization film 106 is disposed to cover the connecting electrode 116 and the first planarization film 105. The first and second planarization films 105 and 106 can each include an organic material. The organic material can include at least one material from an acrylic resin, a phenolic resin, a polyimide resin, an unsaturated polyester resin, a polyamide resin, a benzocyclobutene resin, a polyphenylene resin, or a polyphenylene sulfide resin.

For example, the connecting electrode 116 can be provided as multiple layers formed of one selected from the group consisting of molybdenum (Mo), aluminum (Al), chromium (Cr), gold (Au), titanium (Ti), nickel (Ni), neodymium (Nd), and copper (Cu), or an alloy thereof. However, the embodiments of the present disclosure are not limited thereto. In some cases, the connecting electrode 116 can be omitted. When the connecting electrode 116 is omitted, one of the first and second source/drain electrodes 114 and 115 can be directly connected to the first electrode 122 of the light emitting device ED.

The light emitting device ED is formed by laminating a first electrode 122, an intermediate layer EL, and a second electrode 126.

The first electrode 122 can act as an anode. The first electrode 122 can pass through a second planarization film 106 and a first planarization film 105 and be connected to a transistor TFT. In the illustrated example, the connecting electrode 116 is further provided between the first electrode 122 and the transistor TFT, and the transistor TFT is connected to the connecting electrode 116 and the connecting electrode 116 is connected to the first electrode 122. However, the second source/drain electrode 115 of the transistor TFT and the first electrode 122 of the light emitting device ED can be directly connected without the connecting electrode 116.

The first electrode 122 can include, for example, a metal material having high reflectivity. For example, the first electrode 122 can be formed as a multilayer structure such as a stacked structure of aluminum (Al) and titanium (Ti) (Ti/Al/Ti), a stacked structure of aluminum (Al) and ITO (ITO/Al/ITO), an APC (Ag/Pd/Cu) alloy, a stacked structure of an APC alloy and ITO (ITO/APC/ITO), a stacked structure of silver (Ag) and molybdenum/titanium alloy (Ag/MoTi), or can include a single layer structure formed of one material selected from silver (Ag), aluminum (Al), molybdenum (Mo), gold (Au), magnesium (Mg), calcium (Ca), and barium (Ba), or an alloy of two or more thereof, but is not limited thereto. The first electrode 122 can be referred to as a "reflective electrode".

An intermediate layer EL is provided on the first electrode 122. The intermediate layer EL can include a red intermediate layer REL in the red subpixel RSP, a green intermediate layer GEL in the green subpixel GSP, and a blue intermediate layer BEL in the blue subpixel BSP. The configuration of the intermediate layer of each subpixel refers to the configuration of FIG. 4.

A red light emitting layer REML can be separately included in the red subpixel RSP, a green light emitting layer GEML can be separately included in the green subpixel GSP, and a blue light emitting layer BEML can be separately included in the blue subpixel BSP. For example, the red light emitting layer REML can be patterned in the red subpixel RSP, the green light emitting layer GEML can be patterned in the green subpixel GSP, and the blue light emitting layer BEML can be patterned in the blue subpixel BSP. However, this is merely provided as an example. The red intermediate layer REL, the green intermediate layer GEL, and the blue intermediate layer BEM can have a tandem structure in which a plurality of stacks are disposed with a charge generation layer therebetween. For example, the light emitting device ED of each subpixel RSP, GSP or BSP can have a plurality of stacks in which the intermediate layer EL is laminated between the first and second electrodes 122 and 126, the first common layer CML1, the respective color emitting layers REML, GEML and BEML, and the second common layer CML2, and can include a charge generation layer between adjacent stacks. The tandem structure includes a charge generation layer between the stacks, and each stack can include one or more light emitting layers. In this tandem structure, the first and second hole transport auxiliary layers having different HOMO energy levels as described above can be applied to at least one stack of the green subpixel.

The edge of the first electrode 122 of each subpixel RSP, GSP, BSP can overlap the bank 150. The area of the first electrode 122 exposed from the bank 150 can be a light emitting portion REM, GEM, or BEM. The bank 150 opens the light emitting portion REM, GEM, or BEM of each subpixel RSP, GSP, BSP. The bank 150 can include an organic or inorganic insulating material.

When voltage is applied to the first electrode 122 and the second electrode 126, holes and electrons move to the organic light emitting layer through the hole injection layer and the hole transport layer and the electron injection layer and the electron transport layer, respectively, and in the organic light emitting layer, holes and electrons combine with each other to form excitons, and the excitons fall from an excited state to a ground state, thereby resulting in light emission.

Among the multiple layers included in the intermediate layer (EL: REL, GEL, BEL), the hole transport common layer CML1 and the electron transport common layer CML2 can be provided in common throughout the entire display area AA.

The second electrode 126 can be a common layer that is commonly disposed in the subpixels SP and applies the same voltage. For this purpose, the second electrode 126 can extend from the display area AA to a part of the non-display area NA.

The second electrode 126 can be a light-transmitting electrode. The second electrode 126 acts as a cathode. The second electrode 126 can include a transparent metal material (TCO, transparent conductive material) such as ITO (indium tin oxide) or IZO (indium zinc oxide) that can transmit light, or a semi-transmissive metal material (semi-transmissive conductive material) such as magnesium (Mg), silver (Ag), or an alloy of magnesium (Mg) and silver (Ag). When the second electrode 126 includes a semi-transmissive metal material, the light emission efficiency can be increased by the microcavity effect. When the second electrode 126 includes a semi-transmissive metal material, the thickness thereof can be small enough to transmit light.

The first electrode 122 can include a reflective electrode to prevent light generated in the intermediate layer EL from being transmitted to the light-shielding component below the first electrode 122. Light generated in the intermediate layer EL resonates between the second electrode 126 and the first electrode 122, and is ultimately emitted upward through the second electrode 126. Since the first electrode 122 includes a reflective component, although the first electrode 122 overlaps the wiring and the transistor TFT, the light emitted from the light emitting device ED can be recognized in the light emitting portion REM, GEM, or BEM without being affected by their arrangement.

An encapsulation layer 140 protecting the light emitting device ED can be further provided on the second electrode 126. The encapsulation layer 140 can be a single layer or multiple layers. When the encapsulation layer 140 is provided as a plurality of layers, it can be formed by laminating at least one inorganic encapsulation film with at least one organic encapsulation film. The inorganic encapsulation film can prevent moisture penetration and the organic encapsulation film can cover particles and flatten the surface. The organic encapsulation film can be located inside the inorganic encapsulation film on a plane. In this case, the inorganic encapsulation film can prevent moisture penetration to the side.

A light emitting device according to one embodiment of the present disclosure has a configuration in which a plurality of hole transport auxiliary layers are separated from a light emitting layer with an electron blocking layer therebetween, and a second hole transport auxiliary layer adjacent to the electron blocking layer is formed of a material having a high HOMO energy level so that, when charges are discharged, the charges easily move beyond the electron blocking layer to the second hole transport auxiliary layer, thereby preventing leakage light caused by charges remaining in the layer adjacent to the light emitting layer.

A light emitting device according to one embodiment of the present disclosure can comprise a first electrode and a second electrode facing each other, a light emitting layer between the first electrode and the second electrode, a hole transport common layer between the first electrode and the light emitting layer, and an electron transport common layer between the light emitting layer and the second electrode, a first hole transport auxiliary layer and a second hole transport auxiliary layer provided sequentially between the hole transport common layer and the light emitting layer and an electron blocking layer between the second hole transport auxiliary layer and the light emitting layer. A HOMO energy level of the second hole transport auxiliary layer can be higher than a HOMO energy level of each of the first hole transport auxiliary layer and the electron blocking layer located on both sides of the second hole transport auxiliary layer.

In a light emitting device according to one embodiment of the present disclosure, a HOMO energy level of the second hole transport auxiliary layer can be higher than a HOMO energy level of the light emitting layer.

In a light emitting device according to one embodiment of the present disclosure, the second hole transport auxiliary layer can have an energy band gap smaller than an energy band gap of each of the first hole transport auxiliary layer and the electron blocking layer.

In a light emitting device according to one embodiment of the present disclosure, the first hole transport auxiliary layer can have a hole mobility larger than that of the second hole transport auxiliary layer.

In a light emitting device according to one embodiment of the present disclosure, a refractive index of the first hole transport auxiliary layer can be larger than 2.0 and a refractive index of the second hole transport auxiliary layer can be lower than that of the first hole transport auxiliary layer.

In a light emitting device according to one embodiment of the present disclosure, the first hole transport auxiliary layer can have one surface in contact with the hole transport common layer and the other surface in contact with the second hole transport auxiliary layer. The electron blocking layer can have one surface in contact with the second hole transport auxiliary layer and the other surface in contact with the light emitting layer.

In a light emitting device according to one embodiment of the present disclosure, a difference between a HOMO energy level of the first hole transport auxiliary layer and a HOMO energy level of the hole transport common layer in contact with the first hole transport auxiliary layer can be 0.15 eV or less.

In a light emitting device according to one embodiment of the present disclosure, a difference between a HOMO energy level of the second hole transport auxiliary layer and a HOMO energy level of the electron blocking layer in contact with the second hole transport auxiliary layer can be 0.25 eV or more.

In a light emitting device according to one embodiment of the present disclosure, a first HOMO energy level difference between the second hole transport auxiliary layer and the electron blocking layer can be greater than a second HOMO energy level difference between the second hole transport auxiliary layer and the first hole transport auxiliary layer.

In a light emitting device according to one embodiment of the present disclosure, the first hole transport auxiliary layer can be thicker than the second hole transport auxiliary layer. A thickness of the first hole transport auxiliary layer can be proportional to a wavelength of color of light emitted from the light emitting layer.

In a light emitting device according to one embodiment of the present disclosure, a thickness of the second hole transport auxiliary layer can be 30Å to 70Å.

In a light emitting device according to one embodiment of the present disclosure, the hole transport common layer can comprise a hole injection layer and a hole transport layer. The hole transport layer can be in contact with the first hole transport auxiliary layer.

In a light emitting device according to one embodiment of the present disclosure, the electron transport common layer can comprise a hole blocking layer, an electron transport layer, and an electron injection layer. The hole blocking layer can be in contact with the light emitting layer.

In a light emitting device according to one embodiment of the present disclosure, the light emitting layer can comprise a phosphorescent dopant having an emission peak at a wavelength of 500 nm to 700 nm.

A light emitting display device according to one embodiment of the present disclosure can comprise a substrate including a plurality of subpixels, the light emitting device provided in at least one of the subpixels and a thin film transistor connected to the light emitting device.

In a light emitting display device according to one embodiment of the present disclosure, the first hole transport auxiliary layer and the second hole transport auxiliary layer can be spaced apart from adjacent subpixels, and the electron blocking layer can be continuous in the plurality of subpixels.

A light emitting display device according to one embodiment of the present disclosure can comprise a substrate comprising a green subpixel, a red subpixel, and a blue subpixel, a first electrode at each of the green subpixel, the red subpixel, and the blue subpixel, a hole transport common layer on the first electrode over the green subpixel, the red subpixel, and the blue subpixel, a green light emitting layer, a red light emitting layer, and a blue light emitting layer on the hole transport common layer at each of the green subpixel, the red subpixel, and the blue subpixel, a first hole transport auxiliary layer, a second hole transport auxiliary layer, and an electron blocking layer provided sequentially between the hole transport common layer and the green light emitting layer in the green subpixel, an electron transport common layer on the green light emitting layer, the red light emitting layer, and the blue light emitting layer over the green subpixel, the red subpixel, and the blue subpixel and a second electrode on the electron transport common layer. A HOMO energy level of the second hole transport auxiliary layer can be higher than a HOMO energy level of each of the first hole transport auxiliary layer and the electron blocking layer located on both sides of the second hole transport auxiliary layer.

A light emitting display device according to one embodiment of the present disclosure can further comprise a third hole transport auxiliary layer, a fourth hole transport auxiliary layer, and the electron blocking layer sequentially provided between the hole transport common layer and the red light emitting layer at the red subpixel. A HOMO energy level of the fourth hole transport auxiliary layer can be higher than a HOMO energy level of each of the third hole transport auxiliary layer and the electron blocking layer located on both sides of the fourth hole transport auxiliary layer.

In a light emitting display device according to one embodiment of the present disclosure, the third hole transport auxiliary layer can be thicker than the first hole transport auxiliary layer.

In a light emitting display device according to one embodiment of the present disclosure, the second hole transport auxiliary layer can be thicker than the fourth hole transport auxiliary layer.

In a light emitting display device according to one embodiment of the present disclosure, the electron blocking layer can be in contact with the second hole transport auxiliary layer at the green subpixel and can be in contact with the fourth hole transport auxiliary layer at the red subpixel.

In a light emitting display device according to one embodiment of the present disclosure, the first hole transport auxiliary layer and the second hole transport auxiliary layer need not overlap the red subpixel and the blue subpixel.

As apparent from the foregoing, the light emitting device and light emitting display device according to the present disclosure have the following effects.

The light emitting device according to one embodiment of the present disclosure has a configuration in which a plurality of hole transport auxiliary layers are separated from a light emitting layer with an electron blocking layer therebetween, and a second hole transport auxiliary layer adjacent to the electron blocking layer is formed of a material having a high HOMO energy level so that, when charges are discharged, the charges easily move beyond the electron blocking layer to the second hole transport auxiliary layer, thereby preventing leakage light caused by charges remaining in the layer adjacent to the light emitting layer.

The second hole transport auxiliary layer is formed of a material having a high surface potential, so that instantaneous discharge is excellent through the contact surface. Therefore, instantaneous discharge is possible from the light emitting layer in the off state to the second hole transport auxiliary layer relatively far, thereby preventing low-grayscale leakage light.

The first hole transport auxiliary layer is formed of a high-refractive index material and thus is optimal for resonance depending on the color of light emitted from the light emitting layer, and the second hole transport auxiliary layer is formed of a material with a lower refractive index than the first hole transport auxiliary layer and thus maximizes the micro-cavity effect and aids the discharge function in the off-state.

The light emitting display devices according to the embodiments of the present disclosure is capable of achieving energy balancing, of preventing the phenomenon of specific light leakage at low grayscale levels, and ultimately of improving the light emitting characteristics by differentially changing the configuration of the hole transport auxiliary layer in each sub-pixel.

It will be apparent to those skilled in the art that various modifications and variations can be made in the present disclosure without departing from the scope of the inventions. Thus, it is intended that the present disclosure covers the modifications and variations of this invention provided they come within the scope of the appended claims and their equivalents.

## Claims

1. A light emitting device comprising:
a first electrode and a second electrode facing each other;
a light emitting layer between the first electrode and the second electrode;
a hole transport common layer between the first electrode and the light emitting layer, and an electron transport common layer between the light emitting layer and the second electrode;
a first hole transport auxiliary layer and a second hole transport auxiliary layer provided sequentially between the hole transport common layer and the light emitting layer; and
an electron blocking layer between the second hole transport auxiliary layer and the light emitting layer,
wherein a highest occupied molecular orbital, HOMO, energy level of the second hole transport auxiliary layer is higher than a HOMO energy level of each of the first hole transport auxiliary layer and the electron blocking layer respectively located on opposite sides of the second hole transport auxiliary layer.

2. The light emitting device according to claim 1, wherein the HOMO energy level of the second hole transport auxiliary layer is higher than a HOMO energy level of the light emitting layer.

3. The light emitting device according to claim 1 or 2, wherein the second hole transport auxiliary layer has an energy band gap smaller than an energy band gap of each of the first hole transport auxiliary layer and the electron blocking layer.

4. The light emitting device according to any preceding claim, wherein the first hole transport auxiliary layer has a hole mobility larger than that of the second hole transport auxiliary layer.

5. The light emitting device according to any preceding claim, wherein a refractive index of the first hole transport auxiliary layer is larger than about 2.0 and a refractive index of the second hole transport auxiliary layer is lower than that of the first hole transport auxiliary layer.

6. The light emitting device according to any preceding claim, wherein the first hole transport auxiliary layer has one surface in contact with the hole transport common layer and another surface in contact with the second hole transport auxiliary layer, and
wherein the electron blocking layer has one surface in contact with the second hole transport auxiliary layer and other surface in contact with the light emitting layer.

7. The light emitting device according to any preceding claim, wherein a difference between the HOMO energy level of the first hole transport auxiliary layer and a HOMO energy level of the hole transport common layer in contact with the first hole transport auxiliary layer is about 0.15 eV or less.

8. The light emitting device according to any preceding claim, wherein a difference between the HOMO energy level of the second hole transport auxiliary layer and the HOMO energy level of the electron blocking layer in contact with the second hole transport auxiliary layer is about 0.25 eV or more.

9. The light emitting device according to any preceding claim, wherein a first HOMO energy level difference between the HOMO energy levels of the second hole transport auxiliary layer and the electron blocking layer is greater than a second HOMO energy level difference between the HOMO energy levels of the second hole transport auxiliary layer and the first hole transport auxiliary layer.

10. The light emitting device according to any preceding claim, wherein a thickness of the first hole transport auxiliary layer is thicker than that of the second hole transport auxiliary layer and the thickness of the first hole transport auxiliary layer is proportional to a wavelength of color of light emitted from the light emitting layer.

11. The light emitting device according to any preceding claim, wherein a thickness of the second hole transport auxiliary layer is about 30Å to 70Å.

12. The light emitting device according to any preceding claim, wherein the hole transport common layer comprises a hole injection layer and a hole transport layer, and
wherein the hole transport layer is in contact with the first hole transport auxiliary layer.

13. The light emitting device according to any preceding claim, wherein the electron transport common layer comprises a hole blocking layer, an electron transport layer, and an electron injection layer, and
wherein the hole blocking layer is in contact with the light emitting layer.

14. The light emitting device according to any preceding claim, wherein the light emitting layer comprises a phosphorescent dopant having an emission peak at a wavelength of about 500 nm to 700 nm.
